(19)

Europäisches
Patentamt
European
Patent Office
Office européen
des brevets

(11) **EP 4 686 343 A1**

(12) **EUROPEAN PATENT APPLICATION**

(43) Date of publication:
**28.01.2026 Bulletin 2026/05**

(51) International Patent Classification (IPC):
**H10D 64/68** (2025.01) **H10B 51/30** (2023.01)
**H10D 30/67** (2025.01) **H10D 30/69** (2025.01)
**H10D 64/01** (2025.01)

(21) Application number: **25172322.7**

(22) Date of filing: **24.04.2025**

(52) Cooperative Patent Classification (CPC):
**H10D 64/689; H10B 51/30; H10D 30/6728;**
**H10D 30/6755; H10D 30/701; H10D 64/033;**
H10B 51/10; H10B 51/20

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **24.07.2024 KR 20240098057**

(71) Applicant: **SAMSUNG ELECTRONICS CO., LTD.**
**Yeongtong-gu**
**Suwon-si, Gyeonggi-do 16677 (KR)**

(72) Inventors:
• **YOO, Sijung**
**16678 Suwon-si (KR)**
• **HEO, Jinseong**
**16678 Suwon-si (KR)**
• **CHOE, Dukhyun**
**16678 Suwon-si (KR)**

(74) Representative: **Elkington and Fife LLP**
**Prospect House**
**8 Pembroke Road**
**Sevenoaks, Kent TN13 1XR (GB)**

(54) **FERROELECTRIC FIELD EFFECT TRANSISTOR, MEMORY DEVICE, AND NEURAL NETWORK DEVICE**

(57) A ferroelectric field effect transistor (100) includes a channel layer (103), a gate electrode (101) facing the channel layer, a ferroelectric layer (102) provided between the channel layer and the gate electrode, an oxygen-deficient layer (104) provided between the channel layer and the ferroelectric layer, a diffusion barrier layer (105) provided between the channel layer and the oxygen-deficient layer and configured to reduce or prevent oxygen exchange between the channel layer and the oxygen-deficient layer, and a source electrode (106) and a drain electrode (107), electrically connected to the channel layer, wherein the channel layer and the oxygen-deficient layer include an oxide semiconductor material, and a concentration of oxygen vacancies in the oxygen-deficient layer may be greater than a concentration of oxygen vacancies in the channel layer.

FIG. 1

EP 4 686 343 A1

**Description**

FIELD OF THE INVENTION

The disclosure relates to a ferroelectric field effect transistor, a memory device, and a neural network device.

BACKGROUND OF THE INVENTION

Ferroelectrics are materials that have ferroelectricity, wherein spontaneous polarization is achieved by aligning internal electric dipole moments of the material such that, even when no electric field is applied from an external electric field source, the internal electric dipole moments remain aligned. Even when a certain voltage is applied to a ferroelectric and the voltage is returned to 0 V, polarization remains semi-permanent in the ferroelectric. Research on applying these ferroelectric properties to logic devices or memory devices is ongoing. For example, in the case of a ferroelectric field effect transistor using a ferroelectric, the threshold voltage of the field effect transistor may vary depending on the direction and intensity of the polarization in the ferroelectric. Logic devices or memory devices may be implemented using threshold voltage variation characteristics of such ferroelectric field effect transistors.

SUMMARY OF THE INVENTION

Provided are a ferroelectric field effect transistor and a memory device, including an oxide semiconductor channel and having an improved memory window.
In addition, provided are a ferroelectric field effect transistor and a memory device, including a diffusion barrier layer configured to prevent and/or reduce channel deterioration.
In addition, provided is a neural network device that includes a ferroelectric field effect transistor.
Additional aspects will be set forth in part in the description which follows and, in part, will be apparent from the description, or may be learned by practice of the presented embodiments of the disclosure.
According to an aspect of at least one embodiment, a ferroelectric field effect transistor includes a channel layer, a gate electrode facing the channel layer, a ferroelectric layer between the channel layer and the gate electrode, an oxygen-deficient layer between the channel layer and the ferroelectric layer, a diffusion barrier layer between the channel layer and the oxygen-deficient layer and configured to reduce or prevent oxygen exchange between the channel layer and the oxygen-deficient layer, and a source electrode and a drain electrode electrically connected to the channel layer, wherein the channel layer and the oxygen-deficient layer each include an oxide semiconductor material, and a concentration of oxygen vacancies in the oxygen-deficient layer may be greater than a concentration of oxygen vacancies in the channel layer.
The diffusion barrier layer may include a nitride material.
For example, the nitride material of the diffusion barrier layer may include at least one of silicon nitride (SiN), hafnium nitride (HfN), or aluminum nitride (AlN).
The oxide semiconductor material of the oxygen-deficient layer may have a stoichiometrically oxygen-deficient composition.
A thickness of the oxygen-deficient layer may be less than a thickness of the channel layer, and a thickness of the diffusion barrier layer may be less than a thickness of the oxygen-deficient layer.
For example, a total thickness of the channel layer and the oxygen-deficient layer may be about 10 nm to about 20 nm, the thickness of the oxygen-deficient layer may be about 1 nm to about 5 nm, and the thickness of the diffusion barrier layer may be about 0.1 nm to about 3 nm.
The ferroelectric field effect transistor further includes a gate intermediate layer between the gate electrode and the ferroelectric layer, and the gate intermediate layer may include at least one amorphous dielectric material, the at least one amorphous dielectric material may include silicon oxide, silicon nitride, aluminum oxide, or silicon oxynitride.
The amorphous dielectric material of the gate intermediate layer may include amorphous silicon oxynitride, the gate intermediate layer may include a first surface adjacent to the gate electrode and a second surface adjacent to the ferroelectric layer, a concentration of nitrogen in the gate intermediate layer may gradually increase from the first surface toward the second surface, and a concentration of oxygen in the gate intermediate layer may gradually decrease from the first surface toward the second surface.
A concentration of oxygen at the first surface of the gate intermediate layer may be higher by a ratio of 10 % or more relative to the concentration of oxygen at the second surface of the gate intermediate layer, and a concentration of nitrogen at the second surface of the gate intermediate layer may be higher by a ratio of 10 % or more relative to a concentration of nitrogen at the first surface of the gate intermediate layer.
A concentration of silicon in the gate intermediate layer may gradually increase from the first surface toward the second surface, and a concentration of silicon at the second surface of the gate intermediate layer may be greater by a ratio of 10 % or more relative to a concentration of silicon at the first surface of the gate intermediate layer.

A ratio of the silicon concentration to the nitrogen concentration at the first surface of the gate intermediate layer may be the same as a ratio of the silicon concentration to the nitrogen concentration at the second surface of the gate intermediate layer.

The gate intermediate layer may include a first gate intermediate layer in contact with the ferroelectric layer and a second gate intermediate layer in contact with the gate electrode, the first gate intermediate layer may include at least one of amorphous silicon nitride or amorphous silicon oxynitride, and the second gate intermediate layer may include amorphous silicon oxide (SiO).

The first gate intermediate layer may include amorphous silicon oxynitride, the first gate intermediate layer may include a first surface adjacent to the gate electrode and a second surface adjacent to the ferroelectric layer, a concentration of nitrogen in the first gate intermediate layer may gradually increase from the first surface toward the second surface, and a concentration of oxygen in the first gate intermediate layer may gradually decrease from the first surface toward the second surface.

A concentration of silicon in the first gate intermediate layer gradually increases from the first surface toward the second surface, and a ratio of the silicon concentration to the nitrogen concentration at the first surface of the first gate intermediate layer may be the same as a ratio of the silicon concentration to the nitrogen concentration at the second surface of the first gate intermediate layer.

The channel layer may include a first surface and a second surface facing each other, the source electrode and the drain electrode may be spaced apart from each other on the first surface of the channel layer, and the gate electrode may be arranged to face the second surface of the channel layer.

The channel layer may include a first surface and a second surface facing each other, the gate electrode is arranged to face the first surface of the channel layer, the source electrode and the drain electrode are spaced apart from each other on the first surface of the channel layer, the diffusion barrier layer is provided between the source electrode and the drain electrode on the first surface of the channel layer, the oxygen-deficient layer is provided between the source electrode and the drain electrode on the diffusion barrier layer, the source electrode is provided to face and be spaced apart from a first side surface of the oxygen-deficient layer, and the drain electrode may be provided to face and be spaced apart from a second side surface of the oxygen-deficient layer opposite to the first side surface.

The channel layer, the diffusion barrier layer, the oxygen-deficient layer, the ferroelectric layer, and the gate electrode may extend in a first direction and may be sequentially arranged in a second direction perpendicular to the first direction, and the source electrode and the drain electrode may be electrically connected to both ends of the channel layer in the first direction.

The channel layer may have a cylindrical shape such that the diffusion barrier layer may surround the channel layer, the oxygen-deficient layer may surround the diffusion barrier layer, the ferroelectric layer may surround the oxygen-deficient layer, and the gate electrode may surround the ferroelectric layer.

According to an aspect of at least one embodiment, a memory device includes a plurality of gate electrodes and a plurality of spacers alternately arranged in a first direction, a channel layer extending in the first direction and spaced apart from the plurality of gate electrodes and the plurality of spacers in a second direction perpendicular to the first direction, a ferroelectric layer extending in the first direction and between the channel layer and the plurality of gate electrodes, an oxygen-deficient layer extending in the first direction and between the ferroelectric layer and the channel layer, and a diffusion barrier layer extending in the first direction and between the oxygen-deficient layer and the channel layer and configured to reduce or prevent oxygen exchange between the channel layer and the oxygen-deficient layer, wherein the channel layer and the oxygen-deficient layer each include an oxide semiconductor material, and a concentration of oxygen vacancies in the oxygen-deficient layer may be greater than a concentration of oxygen vacancies in the channel layer.

According to an aspect of at least one embodiment, a neural network device includes an array of a plurality of synaptic devices, each of the plurality of synaptic devices including an access transistor and a ferroelectric field effect transistor, wherein the ferroelectric field effect transistor includes a channel layer, a gate electrode facing the channel layer, a ferroelectric layer between the channel layer and the gate electrode, an oxygen-deficient layer between the channel layer and the ferroelectric layer, a diffusion barrier layer between the channel layer and the oxygen-deficient layer and configured to reduce or prevent oxygen exchange between the channel layer and the oxygen-deficient layer, and a source electrode and a drain electrode electrically connected to the channel layer, wherein the channel layer and the oxygen-deficient layer each include an oxide semiconductor material, and a concentration of oxygen vacancies in the oxygen-deficient layer may be greater than a concentration of oxygen vacancies in the channel layer.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a cross-sectional view schematically showing a structure of a ferroelectric field effect transistor according to at least one embodiment;

FIG. 2 is a graph showing a concentration distribution of oxygen vacancies in an oxygen-deficient layer and a channel layer of a ferroelectric field effect transistor;

FIG. 3 illustrates an energy band diagram of a ferroelectric layer, an oxygen-deficient layer, a diffusion barrier layer, and a channel layer of a ferroelectric field effect transistor;

FIG. 4 is a graph schematically showing polarization characteristics of a ferroelectric layer according to the concentration of oxygen vacancies in an oxygen-deficient layer;

FIG. 5 is a graph schematically showing a change in a memory window of a ferroelectric field effect transistor according to the concentration of oxygen vacancies in an oxygen-deficient layer;

FIG. 6 is a cross-sectional view schematically showing a structure of a ferroelectric field effect transistor according to at least one embodiment;

FIG. 7 is a graph showing an oxygen concentration gradient and a nitrogen concentration gradient in a gate intermediate layer of a ferroelectric field effect transistor;

FIG. 8 is a cross-sectional view schematically showing a structure of a ferroelectric field effect transistor according to at least one embodiment;

FIG. 9 is a cross-sectional view schematically showing a structure of a ferroelectric field effect transistor according to at least one embodiment;

FIG. 10 is a cross-sectional view schematically showing a structure of a ferroelectric field effect transistor according to at least one embodiment;

FIG. 11 is a cross-sectional view schematically showing a structure of a ferroelectric field effect transistor according to at least one embodiment;

FIG. 12 is a cross-sectional view schematically showing a structure of a ferroelectric field effect transistor according to at least one embodiment;

FIG. 13 is a cross-sectional view schematically showing a structure of a ferroelectric field effect transistor according to at least one embodiment;

FIG. 14 is a cross-sectional view schematically showing a structure of a ferroelectric field effect transistor according to at least one embodiment;

FIG. 15 is a cross-sectional view schematically showing a structure of a ferroelectric field effect transistor according to at least one embodiment;

FIGS. 16 and 17 are vertical and horizontal cross-sectional views schematically showing a structure of a ferroelectric field effect transistor according to at least one embodiment, respectively;

FIG. 18 is a cross-sectional view schematically showing a structure of a ferroelectric field effect transistor according to at least one embodiment;

FIG. 19 is a cross-sectional view schematically showing a structure of a ferroelectric field effect transistor according to at least one embodiment;

FIGS. 20 and 21 are horizontal and vertical cross-sectional views schematically showing a structure of a memory cell string of a memory device according to at least one embodiment, respectively;

FIG. 22 is a cross-sectional view schematically illustrating a structure of a memory cell string of a memory device, according to at least one embodiment;

FIG. 23 is a cross-sectional view schematically illustrating a structure of a memory cell string of a memory device, according to at least one embodiment;

FIG. 24 is a diagram illustrating an equivalent circuit of a memory device according to at least one embodiment;

FIG. 25 is a schematic circuit diagram of a neural network device according to at least one embodiment; and

FIG. 26 is a schematic block diagram showing an example configuration of an electronic device including a neural network device.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, a ferroelectric field effect transistor, a memory device, and a neural network device will be described in detail with reference to the accompanying drawings. In the following drawings, the size of each component in the drawings may be exaggerated for clarity and convenience of description. Additionally, when the terms "about" or "substantially" are used in this specification in connection with a numerical value and/or geometric terms, it is intended that the associated numerical value includes a manufacturing tolerance (e.g., $\pm10\%$) around the stated numerical value. Further, regardless of whether numerical values and/or geometric terms are modified as "about" or "substantially," it will be understood that these values should be construed as including a manufacturing or operational tolerance (e.g., $\pm10\%$) around the stated numerical values and/or geometry. Additionally, whenever a range of values is enumerated, the range includes all values within the range as if recorded explicitly clearly, and may further include the boundaries of the range. Accordingly, "included in" the range of "X" to "Y" includes all values between X and Y, including X and Y. In addition, the embodiments described below are merely examples and various modifications are possible from these embodiments.

Hereinafter, terms "upper" or "top" or "lower" or "bottom" may include not only those directly above/below/left/-right in contact, but also those above/below/left/right without contact. For example, it will also be understood that such spatially relative terms, such as "above", "top", etc., are intended to encompass different orientations of the device in use or operation in addition to the orientation depicted in the figures, and that the device may be otherwise oriented (rotated 90 degrees or at other orientations) and the spatially relative terms used herein interpreted accordingly. The singular expression includes plural expressions unless the context clearly implies otherwise. In addition, when a part "includes" a component, this means that it may further include other components, not excluding other components unless otherwise stated.

The use of the term "the" and similar indicative terms may correspond to both singular and plural. If there is no explicit description or contrary description of the order of the steps or operations constituting the method, these steps or operations may be carried out in an appropriate order and are not necessarily limited to the described order.

Further, the terms "unit", "module" or the like mean a unit that processes at least one function or operation, which may be implemented in and/or enabled by processing circuitry such as hardware, software, or a combination of hardware and software. For example, the processing circuitry may include, but is not limited to, a central processing unit (CPU), an application processor (AP), an arithmetic logic unit (ALU), a graphic processing unit (GPU), a digital signal processor, a microcomputer, a field programmable gate array (FPGA), a System-on-Chip (SoC), a programmable logic unit, a microprocessor, or an application-specific integrated circuit (ASIC), etc. Additionally, elements included in units may be configured to be in communication with each other, e.g., through wires, vias, a bus, and/or the like.

The connection or connection members of lines between the components shown in the drawings exemplarily represent functional connection and/or physical or circuit connections, and may be replaceable or represented as various additional functional connections, physical connections, or circuit connections in an actual device.

The use of all examples or exemplary terms is merely for describing a technical idea in detail and the scope is not limited to the examples or exemplary terms unless limited by the claims.

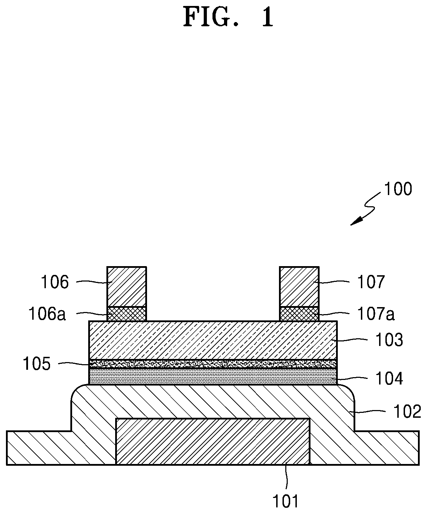

FIG. 1 is a cross-sectional view schematically showing a structure of a ferroelectric field effect transistor according to at least one embodiment. Referring to FIG. 1, a ferroelectric field effect transistor 100 according to at least one embodiment may include a gate electrode 101, a ferroelectric layer 102 surrounding both side surfaces and an upper surface of the gate electrode 101, an oxygen-deficient layer 104 provided on an upper surface of the ferroelectric layer 102, a diffusion barrier layer 105 provided on an upper surface of the oxygen-deficient layer 104, a channel layer 103 provided on an upper surface of the diffusion barrier layer 105, and a source electrode 106 and a drain electrode 107 provided to be electrically connected to the channel layer 103.

The ferroelectric field effect transistor 100 shown in FIG. 1 has a structure referred to as a lower gate structure. In other words, the gate electrode 101 may be provided on the lower side of the ferroelectric field effect transistor 100, and the channel layer 103 may be provided on the upper side of the gate electrode 101 to face the gate electrode 101. The ferroelectric layer 102 may be provided between the gate electrode 101 and the channel layer 103. The oxygen-deficient layer 104 may be provided between the ferroelectric layer 102 and the channel layer 103. The diffusion barrier layer 105 may be provided between the oxygen-deficient layer 104 and the channel layer 103.

The source electrode 106 and the drain electrode 107 may be opposite to the gate electrode 101 with respect to the channel layer 103. For example, the source electrode 106 and the drain electrode 107 may be provided on the upper side of the channel layer 103, and the gate electrode 101 may be provided on the lower side of the channel layer 103. The source electrode 106 and the drain electrode 107 may be spaced apart from each other on the upper surface of the channel layer 103. In other words, the channel layer 103 includes a first surface and a second surface facing each other, the source electrode 106 and the drain electrode 107 may be provided to be spaced apart from each other on the first surface of the channel layer 103, and the gate electrode 101 may be provided facing the second surface of the channel layer 103.

In addition, the oxygen-deficient layer 104 may be provided opposite the source electrode 106 and the drain electrode 107 with respect to the channel layer 103. For example, the source electrode 106 and the drain electrode 107 may be provided above the upper side of the channel layer 103, and the oxygen-deficient layer 104 may be provided on the lower side of the channel layer 103. Since the ferroelectric layer 102 is provided on the lower side of the oxygen-deficient layer 104, the ferroelectric layer 102 may not be in direct contact with the channel layer 103. In other words, the ferroelectric layer 102 may be referred to as being spaced apart from the channel layer 103, with the oxygen-deficient layer 104 therebetween.

The ferroelectric field effect transistor 100 may also optionally further include a first contact layer 106a between the source electrode 106 and the channel layer 103 and a second contact layer 107a between the drain electrode 107 and the channel layer 103, as needed. The first contact layer 106a and the second contact layer 107a may serve to lower contact resistance between the source electrode 106 and the channel layer 103 and contact resistance between the drain electrode 107 and the channel layer 103, respectively. Each of the first contact layer 106a and the second contact layer 107a may include, for example, indium tin oxide (ITO).

The gate electrode 101 may include a conductive material including one or more of a metal, a metal nitride, a metal carbide, polysilicon, or combinations thereof. For example, the metals may include aluminum (Al), tungsten (W), molybdenum (Mo), titanium (Ti), tantalum (Ta), etc., the metal nitrides may include titanium nitride (TiN), tantalum nitride (TaN), etc., and the metal carbides may include aluminum or silicon doped (or containing) metal carbides, for specific example, TiAlC, TaAlC, TiSiC or TaSiC.

The gate electrode 101 may have a structure in which a plurality of materials are stacked. For example, the gate electrode 101 may have a laminated structure of a metal nitride layer/metal layer such as TiN/Al or a laminated structure of a metal nitride layer/metal carbide layer/metal layer such as TiN/TiAlC/W. The gate electrode 101 may include a titanium nitride (TiN) layer or molybdenum (Mo), and the example may be used in various modifications.

In addition, the gate electrode 101 may include a conductive two-dimensional material in addition to the above-described material. For example, the conductive two-dimensional material may include at least one of graphene, black phosphorus, amorphous boron nitride, two-dimensional hexagonal boron nitride (h-BN), and phosphorene.

The ferroelectric layer 102 may include a ferroelectric material. Ferroelectrics are materials with ferroelectricity that maintain spontaneous polarization by aligning internal electric dipole moments even without an electric field being applied from an external electric field source. The threshold voltage of the ferroelectric field effect transistor 100 according to the embodiment may change depending on a polarization direction of the ferroelectric layer 102, for example, a direction from the gate electrode 101 toward the channel layer 103 or vice versa.

The ferroelectric layer 102 may include, for example, a ferroelectric having at least one of a fluorite structure, a perovskite structure, and/or a wurtzite structure. The ferroelectric having a fluoride structure may include, for example, hafnium oxide ($HfO_2$). For example, the hafnium oxide may be doped with at least one element of zirconium (Zr), lanthanum (La), aluminum (Al), silicon (Si), yttrium (Y), and gadolinium (Gd). Alternatively, the ferroelectric layer 102 may include hafnium and zirconium in substantially the same element ratio (e.g., $Hf_{0.5}Zr_{0.5}O_2$), and additionally, at least one element among lanthanum (La), aluminum (Al), silicon (Si), yttrium (Y), and gadolinium (Gd) may be doped by a ratio of less than about 10 at%. The fluorite-based material may comprise a ferroelectric phase (e.g., a crystal phase lacking an inversion center (e.g., is non-centrosymmetric)) in the largest proportion among all crystal phases and/or as a dominant phase. In addition, the ferroelectric having a perovskite structure may include, for example, lead zirconate titanate (PZT). The ferroelectric having a wurtzite structure may include, for example, zinc oxide (ZnO) and/or aluminum nitride (AlN). The ferroelectric of such a wurtzite structure may be doped with, for example, at least one element of boron (B) and/or scandium (Sc). The thickness of the ferroelectric layer 102 may be, for example, about 5 nm to about 20 nm.

The ferroelectric layer 102 may further include an antiferroelectric material. For example, the antiferroelectric material may include zirconium oxide. For example, the zirconium oxide may be doped with at least one element of hafnium (Hf), lanthanum (La), aluminum (Al), silicon (Si), yttrium (Y), and gadolinium (Gd).

The channel layer 103 may include an oxide semiconductor material. The oxide semiconductor material may include an oxide of at least one of indium (In), gallium (Ga), zinc (Zn), tungsten (W), and tin (Sn). For example, the channel layer 103 may include at least one oxide semiconductor material from among indium-gallium-zinc oxide (IGZO), indium-zinc oxide (IZO), gallium-zinc oxide (GZO), zinc oxide (ZnO), zinc-tin oxide (ZTO), indium tungsten oxide (IWO), $In_2O_3$, $Ga_2O_3$, $SnO_2$, and/or $WO_3$. In addition, the channel layer 103 may include an oxide semiconductor material further doped with at least one metal from among aluminum (Al), cadmium (Cd), copper (Cu), silicon (Si), zirconium (Zr), magnesium (Mg), and hafnium (Hf). In addition to the above-described materials, the channel layer 103 may include various other oxide semiconductor materials such as $INb_2O_5$, $TiSrO_3$, and the like.

Since the ferroelectric field effect transistor 100 uses an oxide semiconductor material as the channel layer 103, the ferroelectric field effect transistor 100 may have relatively low leakage current characteristics in an off state and may have a relatively fast operation speed due to high electron mobility of the oxide semiconductor material. In addition, since an insulating interface layer that causes unnecessary parasitic capacitance is not naturally generated on the surface of the oxide semiconductor material, a memory window, which is a difference between two different threshold voltages of the ferroelectric field effect transistor 100, may increase.

Meanwhile, within the channel layer 103 containing the oxide semiconductor material described above, there may be almost no minority carriers due to the high bandgap of the oxide semiconductor material. For example, there may be almost no holes in the channel layer 103. For this reason, when the channel layer 103 and the ferroelectric layer 102 are in direct contact with each other, the ferroelectric layer 102 may have polarization in only one direction. For example, even if a voltage higher than a coercive voltage is applied to the gate electrode 101 of the ferroelectric field effect transistor 100, polarization switching hardly occurs in the ferroelectric layer 102, and only the intensity of polarization may change.

Therefore, when the channel layer 103 and the ferroelectric layer 102 come into direct contact with each other, the memory window of the ferroelectric field effect transistor 100 may be reduced.

According to at least one embodiment, an oxygen-deficient layer 104 is provided between the ferroelectric layer 102 and the channel layer 103 to enable polarization switching of the ferroelectric layer 102. Like the channel layer 103, the oxygen-deficient layer 104 includes an oxide semiconductor material; however the oxygen-deficient layer 104 has a higher concentration of oxygen vacancies than the channel layer 103. The oxygen-deficient layer 104 having a relatively high concentration of oxygen vacancies may increase the amount of depletion charge having a positive charge value in a depletion region. Therefore, the ferroelectric layer 102 is in direct contact with the oxygen-deficient layer 104 between the ferroelectric layer 102 and the channel layer 103, or the ferroelectric layer 102 is positioned closer to the oxygen-deficient layer 104 than the channel layer 103, and thus, the ferroelectric layer 102 may be enabled to switch polarization in both directions. As a result, the memory window of the ferroelectric field effect transistor 100 may be further increased.

The oxygen-deficient layer 104 may include an oxide semiconductor material including an oxide of at least one metal from among indium (In), gallium (Ga), zinc (Zn), tungsten (W), and tin (Sn), for example. The oxygen-deficient layer 104 and the channel layer 103 may include the same oxide semiconductor material as a base material, or may include different oxide semiconductor materials. For example, both the channel layer 103 and the oxygen-deficient layer 104 may include IGZO, or the channel layer 103 may include IGZO and the oxygen-deficient layer 104 may include IZO.

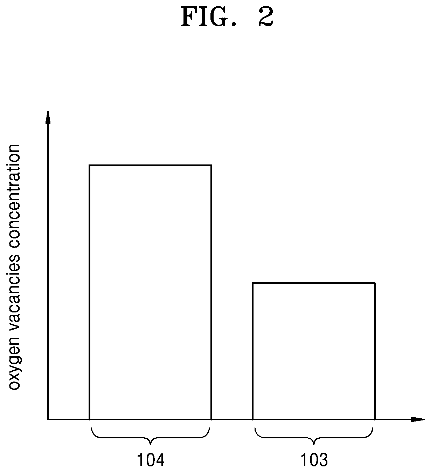

FIG. 2 is a graph showing the concentration distribution of oxygen vacancies in the oxygen-deficient layer 104 and the channel layer 103 of the ferroelectric field effect transistor 100. Referring to FIG. 2, a concentration of oxygen vacancies in the oxygen-deficient layer 104 may be higher than a concentration of oxygen vacancies in the channel layer 103. For example, the concentration of oxygen vacancies in the oxygen-deficient layer 104 may be about 1.2 times or more, about 1.5 times or more, or about twice as high as the concentration of oxygen vacancies in the channel layer 103. The concentration of oxygen vacancies may be measured, for example, using secondary ion mass spectrometry (SIMS) or X-ray photoelectron spectroscopy (XPS).

Oxygen vacancies in the oxygen-deficient layer 104 may be formed by deficiently supplying an oxygen material in the process of forming the oxygen-deficient layer 104. For example, the oxygen-deficient layer 104 may be formed by sputtering, atomic layer deposition (ALD), or chemical vapor deposition (CVD). In the process of depositing the oxide semiconductor material of the oxygen-deficient layer 104, oxygen vacancies may be formed in the oxygen-deficient layer 104 by supplying oxygen into the chamber in a stoichiometrically deficient manner, and the concentration of the oxygen vacancies may be adjusted according to the amount of oxygen provided in the chamber. Therefore, the oxide semiconductor material of the oxygen-deficient layer 104 may have a stoichiometrically oxygen-deficient composition.

In addition, when the channel layer 103 and the oxygen-deficient layer 104 are in direct contact with each other, the channel layer 103 may deteriorate due to oxygen exchange between the channel layer 103 and the oxygen-deficient layer 104. For example, if the ferroelectric field effect transistor 100 repeats the write operation, the oxygen-deficient layer 104 expands as the concentration of oxygen vacancies in the channel layer 103 gradually increases, which may lead to an increase in leakage current while the ferroelectric field effect transistor 100 is turned off. A diffusion barrier layer 105 may be provided between the channel layer 103 and the oxygen-deficient layer 104 to minimize or prevent deterioration of the channel layer 103 by reducing or preventing oxygen exchange between the channel layer 103 and the oxygen-deficient layer 104. In at least some embodiments, the diffusion barrier layer 105 may include a nitride material as a material for reducing or preventing oxygen exchange between the channel layer 103 and the oxygen-deficient layer 104. For example, the diffusion barrier layer 105 may include at least one of silicon nitride (SiN), hafnium nitride (HfN), and aluminum nitride (AlN).

The total thickness of the channel layer 103, the diffusion barrier layer 105, and the oxygen-deficient layer 104 may be about 10 nanometers (nm) to about 20 nm. If the thickness of the oxygen-deficient layer 104 is too large, the threshold voltage of the ferroelectric field effect transistor 100 may be shifted in a negative (-) direction, resulting in deterioration of leakage current characteristics in an off state. Therefore, the thickness of the oxygen-deficient layer 104 may be less than the thickness of the channel layer 103. For example, the thickness of the oxygen-deficient layer 104 may be about 1 nm to about 5 nm to minimize a leakage current while enabling the ferroelectric layer 102 to switch polarization in both directions. The diffusion barrier layer 105 may have a thickness sufficient to prevent (and/or reduce to a rate within tolerance) oxygen exchange between the channel layer 103 and the oxygen-deficient layer 104. In addition, the diffusion barrier layer 105 may have a small thickness that minimizes a voltage drop caused by the diffusion barrier layer 105 so that an electric field may be efficiently applied to the channel layer 103 by minimizing a voltage loss caused by the diffusion barrier layer 105. To this end, the thickness of the diffusion barrier layer 105 may be less than the thickness of the oxygen-deficient layer 104. For example, the diffusion barrier layer 105 may have a thickness less than a thickness of the oxygen-deficient layer 104 within a range of about 0.1 nm to about 3 nm.

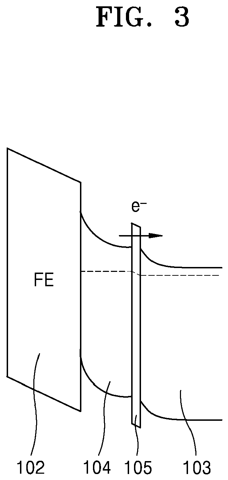

FIG. 3 illustrates an energy band diagram of the ferroelectric layer 102, the oxygen-deficient layer 104, the diffusion barrier layer 105, and the channel layer 103 of the ferroelectric field effect transistor 100. Referring to FIG. 3, the energy bandgap of the diffusion barrier layer 105 may be greater than the energy bandgap of the oxygen-deficient layer 104 adjacent to the diffusion barrier layer 105 and the energy bandgap of the channel layer 103 adjacent thereto. However, since the thickness of the diffusion barrier layer 105 is sufficiently small and the difference between the conduction band energy of the ferroelectric layer 102 and the conduction band energy of the channel layer 103 is sufficiently large while the voltage is applied to the gate electrode 101 of the ferroelectric field effect transistor 100, an electric field may be sufficiently applied to the channel layer 103. In FIG. 3, a dotted line indicates a Fermi level.

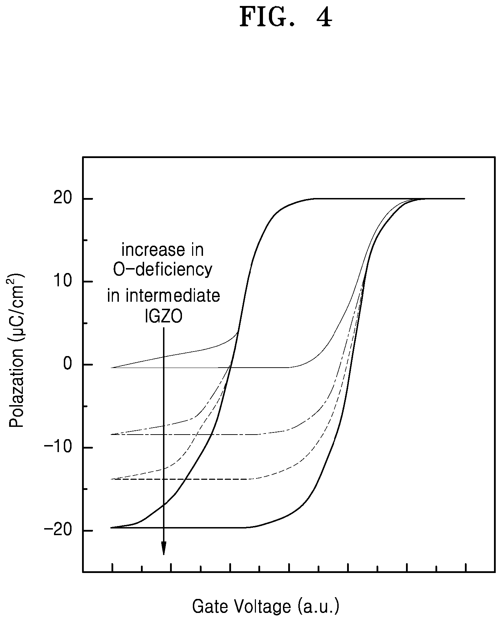

FIG. 4 is a graph schematically showing polarization characteristics of the ferroelectric layer 102 according to the concentration of oxygen vacancies in the oxygen-deficient layer 104. Referring to FIG. 4, the polarization direction and the polarization intensity of the ferroelectric layer 102 may vary according to the voltage applied to the gate electrode 101 of the ferroelectric field effect transistor 100. When there are not enough oxygen vacancies in the oxygen-deficient layer 104, for example, when the concentration of oxygen vacancies in the oxygen-deficient layer 104 is approximately the same as the concentration of oxygen vacancies in the channel layer 103, the polarization of the ferroelectric layer 102 changes only between 0 (zero) and positive (+) values. In other words, the polarization of the ferroelectric layer 102 has only one direction, and polarization switching does not occur in both directions. If the concentration of oxygen vacancies in the oxygen-deficient layer 104 is sufficiently high, polarization switching may occur in both directions in the ferroelectric layer 102. In other words, the polarization of the ferroelectric layer 102 may vary between a negative (-) value and a positive (+) value. As the concentration of oxygen vacancies in the oxygen-deficient layer 104 increases, the negative maximum value of polarization of the ferroelectric layer 102 may increase.

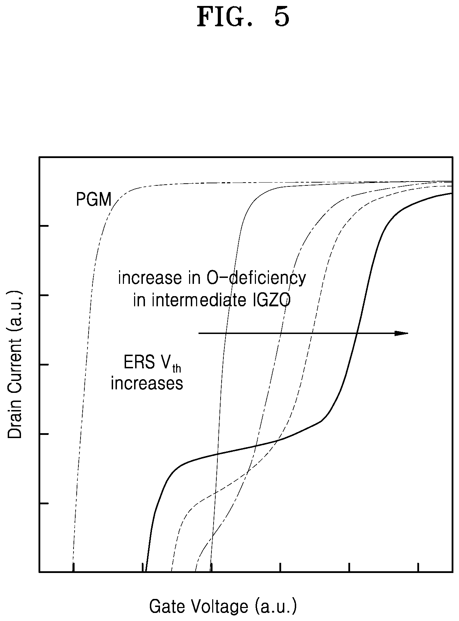

FIG. 5 is a graph schematically showing a change in a memory window of the ferroelectric field effect transistor 100 according to concentration of oxygen vacancies in the oxygen-deficient layer 104. The ferroelectric field effect transistor 100 may have a first threshold voltage which is relatively low and a second threshold voltage which is relatively high, according to the direction and intensity of polarization in the ferroelectric layer 102. The threshold voltage of the ferroelectric field effect transistor 100 may be a voltage when the current flowing between the source electrode 106 and the drain electrode 107 is saturated while gradually increasing the gate voltage applied to the gate electrode 101. When the ferroelectric field effect transistor 100 has the first threshold voltage, it may be called a "program (PGM)" state, and when the ferroelectric field effect transistor 100 has the second threshold voltage, it may be called an "erase (ERS)" state. The first threshold voltage may be constant regardless of the concentration of oxygen vacancies in the oxygen-deficient layer 104. On the contrary, as the concentration of oxygen vacancies in the oxygen-deficient layer 104 increases, the second threshold voltage may increase. Accordingly, as the concentration of oxygen vacancies in the oxygen-deficient layer 104 increases, a memory window, which is a difference between the first threshold voltage and the second threshold voltage, may increase.

As described above, since the ferroelectric field effect transistor 100 uses the oxide semiconductor material as the channel layer 103, the ferroelectric field effect transistor 100 may have a relatively low leakage current in an off state and a relatively high operation speed due to a high electron mobility of the oxide semiconductor material. In addition, since the ferroelectric field effect transistor 100 includes the oxygen-deficient layer 104 having a high oxygen vacancies concentration between the channel layer 103 and the ferroelectric layer 102, the ferroelectric layer 102 may be enabled to switch polarization between two opposite directions. Accordingly, the memory window of the ferroelectric field effect transistor 100 according to the embodiments may be improved. In addition, the ferroelectric field effect transistor 100 further includes a diffusion barrier layer 105 for reducing or preventing oxygen exchange between the channel layer 103 and the oxygen-deficient layer 104, thereby preventing deterioration of the channel layer 103 according to the operation of the ferroelectric field effect transistor 100.

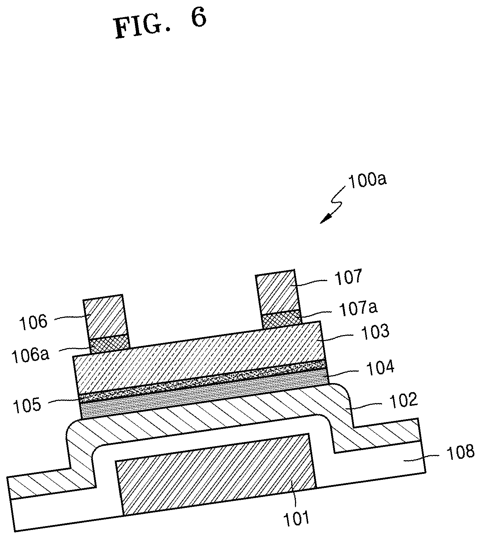

FIG. 6 is a cross-sectional view schematically showing a structure of a ferroelectric field effect transistor according to at least one embodiment. Referring to FIG. 6, a ferroelectric field effect transistor 100a according to at least one embodiment may further include a gate intermediate layer 108 provided between the gate electrode 101 and the ferroelectric layer 102. The configuration of the ferroelectric field effect transistor 100a except for the gate intermediate layer 108 is the same as or substantially similar to that of the ferroelectric field effect transistor 100 shown in FIG. 1, and thus, repeats of the detailed description thereof is omitted.

The memory window (MW) of the ferroelectric field effect transistor 100a may be expressed by Equation 1 below.

[Equation 1]

$$MW = \frac{\Delta P - \Delta Q_{it}}{C_{FE}} + \frac{\Delta Q'_{it} - \Delta Q_{it}}{C_{TD}}$$

In Equation 1 above, $\Delta P$ represents the polarization amount or polarization intensity of the ferroelectric layer 102, $\Delta Q_{it}$ represents the amount of charge trapped at the interface of the ferroelectric layer 102 facing the channel layer 103, $\Delta Q'_{it}$ represents the amount of charge trapped at the interface of the ferroelectric layer 102 facing the gate electrode 101, $C_{FE}$ represents the capacitance of the ferroelectric layer 102, and $C_{TD}$ represents the capacitance between the ferroelectric layer 102 and the gate electrode 101.

As may be seen from Equation 1 above, as the capacitance between the ferroelectric layer 102 and the gate electrode 101 decreases, the memory window MW of the ferroelectric field effect transistor 100a increases. Thus, the gate intermediate layer 108 may be provided to further increase the memory window MW of the ferroelectric field effect transistor 100a by lowering the capacitance between the ferroelectric layer 102 and the gate electrode 101. To this end, the gate intermediate layer 108 may include a dielectric material having a relatively low dielectric constant. For example, the gate intermediate layer 108 may include at least one amorphous dielectric material from among silicon oxide (SiO), silicon nitride (SiN), aluminum oxide (AlO), and silicon oxynitride (SiON). The thickness of the gate intermediate layer 108 may be about 1 nm to about 5 nm, or about 3 nm to about 5 nm.

When the gate intermediate layer 108 includes amorphous silicon oxynitride (SiON), the gate intermediate layer 108 may further increase the memory window by increasing the amount $\Delta Q'_{it}$ of charges trapped at the interface of the ferroelectric layer 102 facing the gate electrode 101. In addition, the gate intermediate layer 108 including amorphous silicon oxynitride (SiON) may prevent or minimize the deterioration of surrounding layers by preventing or reducing the diffusion of oxygen. To this end, the concentration of oxygen in the gate intermediate layer 108 may gradually decrease as it approaches the ferroelectric layer 102 and gradually increase as it approaches the gate electrode 101. In contrast to oxygen, the concentrations of nitrogen and silicon within the gate intermediate layer 108 may gradually increase with distance towards the ferroelectric layer 102 and gradually decrease with distance towards the gate electrode 101. Therefore, the concentration gradient of oxygen and the concentration gradients of nitrogen and silicon may appear oppositely in the gate intermediate layer 108. In other words, the gate intermediate layer 108 includes a first surface adjacent to the gate electrode 101 and a second surface adjacent to the ferroelectric layer 102, and the concentration of oxygen in the gate intermediate layer 108 may gradually decrease from the first surface toward the second surface, and the concentrations of nitrogen and silicon may gradually increase from the first surface toward the second surface.

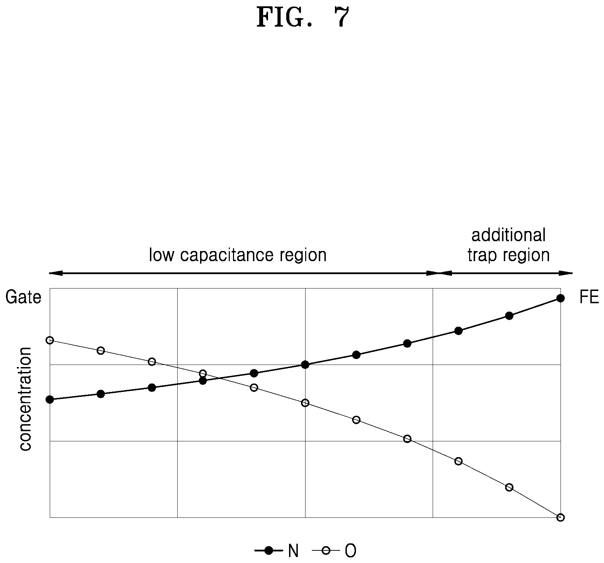

FIG. 7 is a graph showing an oxygen concentration gradient and a nitrogen concentration gradient in a gate intermediate layer 108 of a ferroelectric field effect transistor 100a. In the graph of FIG. 7, the horizontal axis indicates the distance from the lower surface (or first surface) of the gate intermediate layer 108 facing the gate electrode 101 toward the upper surface (or second surface) of the gate intermediate layer 108 facing the ferroelectric layer 102, and the vertical axis indicates the concentrations of oxygen and nitrogen in the gate intermediate layer 108. As shown in FIG. 7, the gate intermediate layer 108 may have an oxygen concentration gradient that gradually decreases from the first surface toward the second surface. In other words, the oxygen concentration may be the highest on the first surface of the gate intermediate layer 108 adjacent to the gate electrode 101, and the oxygen concentration may gradually decrease toward the second surface of the gate intermediate layer 108 adjacent to the ferroelectric layer 102, so that the oxygen concentration may be the lowest on the second surface of the gate intermediate layer 108.

For example, relative to the oxygen concentration at the second surface of the gate intermediate layer 108, the oxygen concentration at the first surface of the gate intermediate layer 108 may be higher by a ratio of about 10 % or more, about 50 % or more, about 100 % or more, and/or about 300 % or more. The difference between the oxygen concentration at the first surface of the gate intermediate layer 108 and the oxygen concentration at the second surface of the gate intermediate layer 108 may be about 5 at% or more, about 10 at% or more, and/or about 20 at% or more. If the difference in oxygen concentrations between the first surface and the second surface of the gate intermediate layer 108 is about 5 at% or more, oxygen may be sufficiently prevented or reduced from passing through the gate intermediate layer 108, so that a maximum difference in oxygen concentrations between the upper and lower portions of the gate intermediate layer 108 does not need to be limited. However, considering the amount of oxygen that can be bonded to the gate intermediate layer 108, the difference between the oxygen concentration at the first surface of the gate intermediate layer 108 and the oxygen concentration at the second surface of the gate intermediate layer 108 may be about 60 at% or less.

In addition, the concentration of silicon (Si) and the concentration of nitrogen (N) may change according to the change in the concentration of oxygen in the gate intermediate layer 108. Referring to FIG. 7, the gate intermediate layer 108 may have a nitrogen concentration gradient that gradually increases from the first surface toward the second surface. In other words, the nitrogen concentration may be the lowest on the first surface of the gate intermediate layer 108, and the nitrogen concentration may gradually increase toward the second surface of the gate intermediate layer 108, so that the nitrogen concentration may be the maximum on the second surface of the gate intermediate layer 108. For example, relative to the nitrogen concentration at the first surface of the gate intermediate layer 108, the nitrogen concentration at the second surface of the gate intermediate layer 108 may be higher by a ratio of about 10% or more, about 20% or more, about 50% or more, and/or about 100% or more. The difference between the nitrogen concentration at the second surface of the gate intermediate layer 108 and the nitrogen concentration at the first surface of the gate intermediate layer 108 may be about 5 at% or more, about 10 at% or more, or about 20 at% to about 60 at%.

Although not shown in FIG. 7, like nitrogen, the silicon concentration may be the lowest on the first surface of the gate intermediate layer 108, and the silicon concentration may gradually increase toward the second surface of the gate intermediate layer 108, so that the silicon concentration may be the maximum on the second surface of the gate intermediate layer 108. For example, compared to the silicon concentration at the first surface of the gate intermediate layer 108, the silicon concentration at the second surface of the gate intermediate layer 108 may be higher by a ratio of about 10% or more, about 20% or more, about 50% or more, or about 100% or more. The difference between the silicon concentration at the second surface of the gate intermediate layer 108 and the silicon concentration at the first surface of the gate intermediate layer 108 may be about 5 at% or more, about 10 at% or more, or about 20 at% to about 60 at%.

A ratio of the silicon concentration to the nitrogen concentration in the gate intermediate layer 108 may be constant. In other words, the ratio of the silicon concentration to the nitrogen concentration may not change within all regions of the gate intermediate layer 108. Therefore, the ratio of the silicon concentration to the nitrogen concentration at the first surface of the gate intermediate layer 108 may be the same as the ratio of the silicon concentration to the nitrogen concentration at the second surface of the gate intermediate layer 108. Here, the term "the same" does not mean "the perfectly identical", and if the deviation of the ratio of the silicon concentration to the nitrogen concentration at the first and second surfaces of the gate intermediate layer 108 is within about 5 %, both parts may be considered the same.

According to the concentration gradients of elements inside the gate intermediate layer 108, the dielectric constant of the gate intermediate layer 108 may decrease due to the high oxygen concentration toward the first surface of the gate intermediate layer 108 far away from the ferroelectric layer 102, and thus the capacitance may decrease. In addition, the charge trap may increase due to the high nitrogen concentration toward the second surface of the gate intermediate layer 108 close to the ferroelectric layer 102. Therefore, a charge trap may be additionally formed in a region close to the interface with the ferroelectric layer 102, and a memory window may be further increased. In addition, oxygen and nitrogen may exist in excess of silicon in stoichiometry in the gate intermediate layer 108. Then, defects such as oxygen vacancies or nitrogen vacancies may hardly exist inside the gate intermediate layer 108.

The memory window of the ferroelectric field effect transistor 100a shown in FIG. 6 may increase as the thickness of the gate intermediate layer 108 increases, and may increase as the pulse width of a driving voltage (e.g., a program voltage or an erase voltage) increases. According to at least one embodiment, even when the thickness of the gate intermediate layer 108 is 3 nm and the pulse width of the driving voltage is 1 microsecond ($\mu$s) which is relatively narrow, a relatively large memory window of about 10 V or more may be secured.

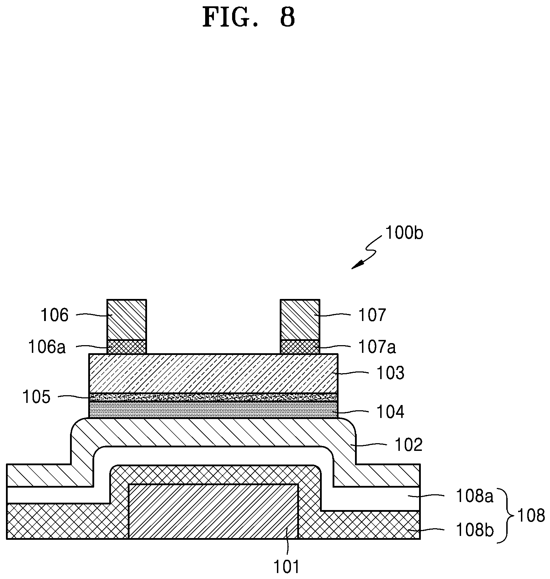

FIG. 8 is a cross-sectional view schematically showing a structure of a ferroelectric field effect transistor according to at least one embodiment. Referring to FIG. 8, in a ferroelectric field effect transistor 100b according to at least one embodiment, a gate intermediate layer 108 may have a multi-layered structure. For example, the gate intermediate layer 108 may include a first gate intermediate layer 108a adjacent to or in contact with the ferroelectric layer 102 and a second gate intermediate layer 108b adjacent to and/or in contact with the gate electrode 101. The first gate intermediate layer 108a may prevent or minimize deterioration of surrounding layers by preventing or reducing diffusion of oxygen. The second gate intermediate layer 108b may serve to provide low capacitance. For example, in at least some embodiments, the first gate intermediate layer 108a may include amorphous silicon nitride (SiN) and/or amorphous silicon oxynitride (SiON). The second gate intermediate layer 108b may include amorphous silicon oxide (SiO) having a relatively low dielectric constant.

When the first gate intermediate layer 108a includes amorphous silicon oxynitride (SiON), as described with reference to FIG. 7, the concentration of oxygen in the first gate intermediate layer 108a may decrease with distance approaching the ferroelectric layer 102 and increase as with distance approaching the gate electrode 101, and the concentrations of nitrogen and silicon may increase with distance approaching the ferroelectric layer 102 and decrease with distance approaching the gate electrode 101. In other words, the first gate intermediate layer 108a includes a first surface adjacent to the gate electrode 101 and a second surface adjacent to the ferroelectric layer 102, and the concentration of oxygen in the first gate intermediate layer 108a may gradually decrease from the first surface toward the second surface, and the concentrations of nitrogen and silicon may gradually increase from the first surface toward the second surface. Then, the first gate intermediate layer 108a may increase the amount of electric charges trapped at the interface of the ferroelectric layer 102 to further increase the memory window.

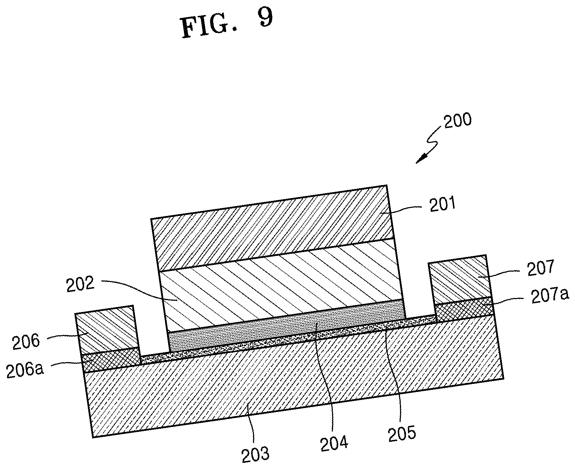

FIG. 9 is a cross-sectional view schematically showing a structure of a ferroelectric field effect transistor according to at least one embodiment. Although the lower gate structure in which the gate electrode 101 is provided below has been described so far, the ferroelectric field effect transistor according to at least some embodiments does not need to be limited to the lower gate structure, and may have an upper gate structure in which the gate electrode is provided above the channel. Referring to FIG. 9, the ferroelectric field effect transistor 200 may include a channel layer 203, a diffusion barrier layer 205 provided on an upper surface of the channel layer 203, an oxygen-deficient layer 204 on an upper surface of the diffusion barrier layer 205; a ferroelectric layer 202 provided on an upper surface of the oxygen-deficient layer 204, a gate electrode 201 provided on an upper surface of the ferroelectric layer 202, and a source electrode 206 and a drain electrode 207 provided on an upper surface of the channel layer 203 to face on both sides of the diffusion barrier layer 205, respectively. The ferroelectric field effect transistor 200 may also optionally further include a first contact layer 206a between the source electrode 206 and the channel layer 203 and a second contact layer 207a between the drain electrode 207 and the channel layer 203, as needed. Since the materials, compositions, and functions of the layers shown in FIG. 9 are the same as or substantially similar to the materials, compositions, and functions of the layers described with reference to FIG. 1, the repeating of detailed descriptions thereof is omitted and differences are mainly described below.

The ferroelectric field effect transistor 200 shown in FIG. 9 has a structure which may be referred to as an upper gate structure. In other words, the gate electrode 201 is provided on the upper side of the ferroelectric field effect transistor 200. The gate electrode 201 may be provided on the upper side of the channel layer 203 to face the channel layer 203. The ferroelectric layer 202 may be provided between the upper surface (that is, the first surface) of the channel layer 203 and the lower surface of the gate electrode 201. The oxygen-deficient layer 204 may be provided between the upper surface of the channel layer 203 and the lower surface of the ferroelectric layer 202. In addition, the diffusion barrier layer 205 may be provided between the upper surface of the channel layer 203 and the lower surface of the oxygen-deficient layer 204. The source electrode 206 and the drain electrode 207 may be provided on the same side as the gate electrode 201 with respect to the channel layer 203. In other words, the source electrode 206 and the drain electrode 207 may also be provided to be spaced apart from each other on the upper surface of the channel layer 203 like the gate electrode 201. The channel layer 203 may be provided as a region of a semiconductor substrate corresponding to the gate electrode 201 and/or between the source electrode 206 and the drain electrode 207 and/or may be provided as a semiconductor layer provided on top of a substrate (not illustrated).

The diffusion barrier layer 205 may be provided between the source electrode 206 and the drain electrode 207 on the upper surface of the channel layer 203. The diffusion barrier layer 205 may or may not be in contact with the source electrode 206 or the drain electrode 207. Although FIG. 9 illustrates that the first side surface of the diffusion barrier layer 205 contacts the source electrode 206 and the second side surface of the diffusion barrier layer 205 opposite to the first side surface contacts the drain electrode 207, embodiments are not necessarily limited thereto. The source electrode 206 may be spaced apart from the first side surface of the diffusion barrier layer 205, and the drain electrode 207 may be spaced apart from the second side surface of the diffusion barrier layer 205.

The oxygen-deficient layer 204 may be provided between the source electrode 206 and the drain electrode 207 on the upper surface of the diffusion barrier layer 205. The source electrode 206 and the drain electrode 207 may not be in direct contact with the oxygen-deficient layer 204. The source electrode 206 may be provided to face and be spaced apart from a first side surface of the oxygen-deficient layer 204. The drain electrode 207 may face and be spaced apart from the second side surface opposite to the first side surface of the oxygen-deficient layer 204.

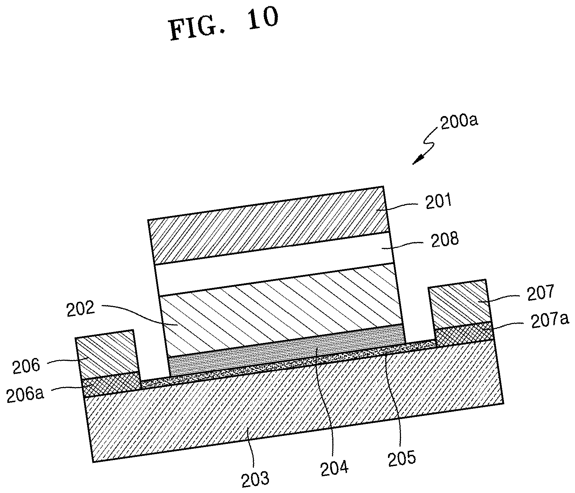

FIG. 10 is a cross-sectional view schematically showing a structure of a ferroelectric field effect transistor according to at least one embodiment. Referring to FIG. 10, a ferroelectric field effect transistor 200a may further include a gate intermediate layer 208 provided between a gate electrode 201 and a ferroelectric layer 202. Otherwise, the gate intermediate layer 208 may be the same as (or substantially similar to) the gate intermediate layer 108 described with reference to FIG. 6. For example, the gate intermediate layer 208 may include at least one amorphous dielectric material from among silicon oxide (SiO), silicon nitride (SiN), aluminum oxide (AlO), and silicon oxynitride (SiON). When the gate intermediate layer 208 includes amorphous silicon oxynitride (SiON), the concentration of oxygen in the gate intermediate layer 208 decreases as it gets closer to the ferroelectric layer 202 and increases as it gets closer to the gate electrode 201, and the concentrations of nitrogen and silicon may increase as it gets closer to the ferroelectric layer 202 and decrease as it gets closer to the gate electrode 201.

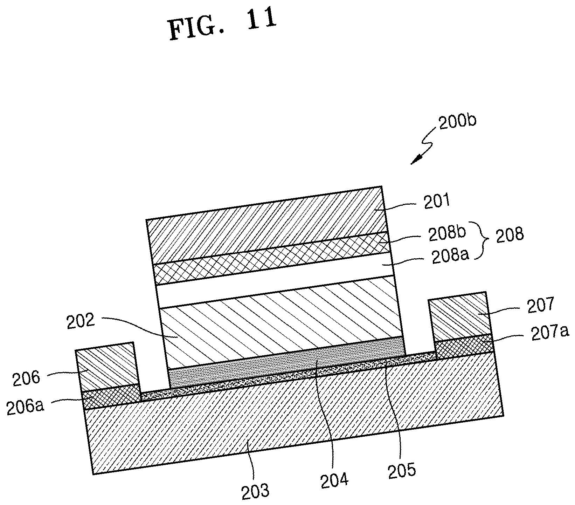

FIG. 11 is a cross-sectional view schematically showing a structure of a ferroelectric field effect transistor according to at least one embodiment. Referring to FIG. 11, in a ferroelectric field effect transistor 200b according to at least one embodiment, a gate intermediate layer 208 may have a multi-layered structure. For example, the gate intermediate layer 208 may include a first gate intermediate layer 208a adjacent to the ferroelectric layer 202 and a second gate intermediate layer 208b adjacent to the gate electrode 201. Otherwise, the first gate intermediate layer 208a may be the same as (or substantially similar to) the first gate intermediate layer 108a described with reference to FIG. 8, and the second gate intermediate layer 208b may be the same as (or substantially similar to) the second gate intermediate layer 108b described with reference to FIG. 8. For example, the first gate intermediate layer 208a may include amorphous silicon nitride (SiN) or amorphous silicon oxynitride (SiON), and the second gate intermediate layer 208b may include amorphous silicon oxide (SiO) having a relatively low dielectric constant. When the first gate intermediate layer 208a includes amorphous silicon oxynitride (SiON), the concentration of oxygen in the gate intermediate layer 208a decreases with distance towards to the ferroelectric layer 202 and increases as with distance towards the gate electrode 201, and the concentrations of nitrogen and silicon may increase with distance towards to the ferroelectric layer 202 and decrease with distance towards to the gate electrode 201. In other words, the first gate intermediate layer 208a includes a first surface adjacent to the gate electrode 201 and a second surface adjacent to the ferroelectric layer 202, and the concentration of oxygen in the first gate intermediate layer 208a may gradually decrease from the first surface toward the second surface, and the concentrations of nitrogen and silicon may gradually increase from the first surface toward the second surface.

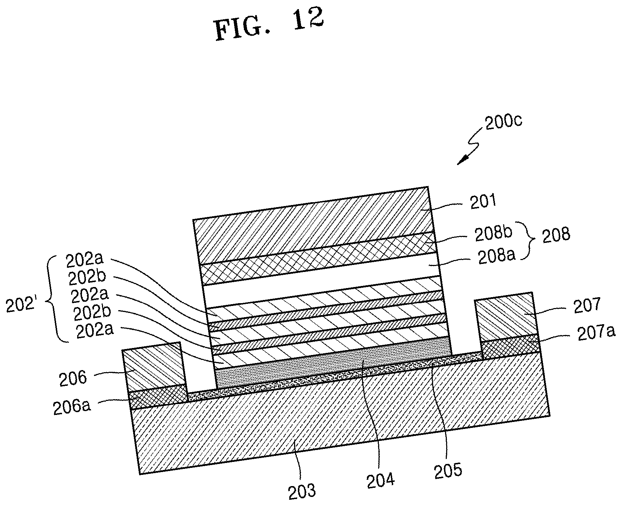

FIG. 12 is a cross-sectional view schematically showing a structure of a ferroelectric field effect transistor according to at least one embodiment. Referring to FIG. 12, a ferroelectric layer 202' of a ferroelectric field effect transistor 200c according to at least one embodiment may include a plurality of first material layers 202a and at least one second material layer 202b between two first material layers 202a facing each other. Although three first material layers 202a and two second material layers 202b are illustrated in FIG. 12, the numbers of the first material layers 202a and the second material layers 202b are not limited thereto. For example, the ferroelectric layer 202' may include two first material layers 202a and one second material layer 202b, or the ferroelectric layer 202' may include four first material layers 202a and three second material layers 202b. The remaining configuration of the ferroelectric field effect transistor 200c shown in FIG. 12 except for the ferroelectric layer 202' may be the same as or substantially similar to the configuration of the ferroelectric field effect transistor 200b described above.

The first material layer 202a may include the ferroelectric material of the ferroelectric layer 202 described with reference to FIG. 1. For example, the first material layer 202a may include a ferroelectric having at least one of the fluorite structure, the perovskite structure, and the wurtzite structure described above. The second material layer 202b may include a paraelectric material. For example, the second material layer 202b may include at least one paraelectric of $Al_2O_3$, $SiO_2$, $La_2O_3$, and $Y_2O_3$.

In the case of the above-described ferroelectric material, when the thickness is about 10 nm or more, ferroelectric characteristics may begin to gradually deteriorate as the thickness increases. For example, the stability of a ferroelectric phase may decrease with thickness, and therefore, the ferroelectric properties may deteriorate as the thickness of the ferroelectric layer 102 and/or 202 increases. Accordingly, it is difficult to form the ferroelectric layer 102 or 202 into a single layer having a thickness of about 20 nm or more. As shown in FIG. 12, by stacking the plurality of first material layers 202a including a ferroelectric material, the ferroelectric layer 202' (and/or 102) may be formed to have an effective thickness of 20 nm or more without degrading ferroelectric properties. The thickness of each of the first material layers 202a may be, for example, about 5 nm to about 10 nm. In addition, the thickness of the second material layer 202b may be small enough not to deteriorate the ferroelectric characteristics of the ferroelectric layer 202'. For example, the thickness of the second material layer 202b may be about 0.1 nm to about 1 nm.

Although a ferroelectric field effect transistor having a planar channel in a horizontal direction has been described above, it is also possible to implement a ferroelectric field effect transistor having a vertical channel in a vertical direction.

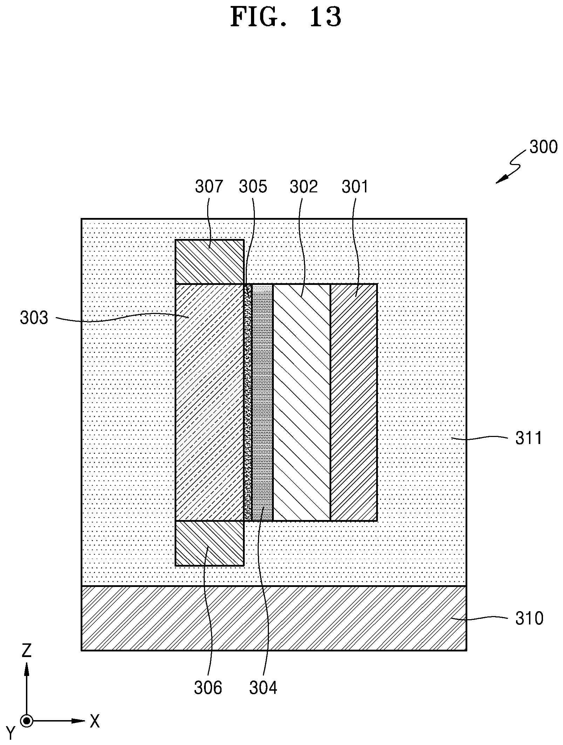

FIG. 13 is a cross-sectional view schematically showing a structure of a ferroelectric field effect transistor according to at least one embodiment. Referring to FIG. 13, a ferroelectric field effect transistor 300 according to at least one embodiment may include a source electrode 306, a channel layer 303 provided on the source electrode 306 and extending in a first direction (e.g., a vertical direction or a Z-axis direction), a drain electrode 307 provided on the channel layer 303, a gate electrode 301 provided to face one side surface of the channel layer 303 in a second direction (e.g., a horizontal direction or an X-axis direction) perpendicular to the first direction, a ferroelectric layer 302 provided between one side surface of the channel layer 303 and the gate electrode 301 in a second direction, an oxygen-deficient layer 304 provided between one side surface of the channel layer 303 and the ferroelectric layer 302 in the second direction, and a diffusion barrier layer 305 provided between one side surface of the channel layer 303 and the oxygen-deficient layer 304 in the second direction. Although not shown in FIG. 13, a first contact layer may be further provided between the source electrode 306 and the channel layer 303 in the first direction, and a second contact layer may be further provided between the drain electrode 307 and the channel layer 303 in the first direction. Since the materials, compositions, and functions of the layers shown in FIG. 13 are the same as (or substantially similar to) the materials, compositions, and functions of the layers described with reference to FIG. 1, the repeating of detailed descriptions thereof is omitted and differences are mainly described below.

As shown in FIG. 13, the channel layer 303, the diffusion barrier layer 305, the oxygen-deficient layer 304, the ferroelectric layer 302, and the gate electrode 301 may be sequentially arranged in the horizontal direction (e.g., the second direction) and extend in the vertical direction (e.g., the first direction). The source electrode 306 and the drain electrode 307 may be provided to be electrically connected to a lower portion and an upper portion or both ends of the channel layer 303 in the vertical direction. The width of the source electrode 306 and the width of the drain electrode 307 in the second direction may be the same as the width of the channel layer 303 or may be slightly (e.g., 10% or less) lesser or greater than the width of the channel layer 303. Even when the width of the source electrode 306 and the width of the drain electrode 307 in the second direction are greater than the width of the channel layer 303, the source electrode 306 and the drain electrode 307 may be in contact with the diffusion barrier layer 305 but may not be in contact with the oxygen-deficient layer 304. In other words, the source electrode 306 and the drain electrode 307 may extend to the diffusion barrier layer 305 in the second direction, but may not extend to the oxygen-deficient layer 304. However, when it is difficult to limit the widths of the source electrode 306 and the drain electrode 307 due to the restriction on the process, the source electrode 306 and the drain electrode 307 may be in contact with the oxygen-deficient layer 304, and in this case, the leakage current may increase slightly. The channel layer 303, the diffusion barrier layer 305, the oxygen-deficient layer 304, the ferroelectric layer 302, and the gate electrode 301 may have the same length in the first direction, but are not limited thereto.

The ferroelectric field effect transistor 300 may further include a substrate 310, and the source electrode 306 may be provided over an upper surface of the substrate 310. The ferroelectric field effect transistor 300 may further include an interlayer insulating layer 311 provided on the substrate 310 to surround the channel layer 303, the diffusion barrier layer 305, the oxygen-deficient layer 304, the ferroelectric layer 302, the gate electrode 301, the source electrode 306, and the drain electrode 307. In FIG. 13, the source electrode 306 is separated from the substrate 310 in the vertical direction (e.g., the first direction), and the interlayer insulating layer 311 is provided between the source electrode 306 and the substrate 310. However, when the substrate 310 is an insulating substrate, the source electrode 306 may be provided to be in direct contact with the upper surface of the substrate 310.

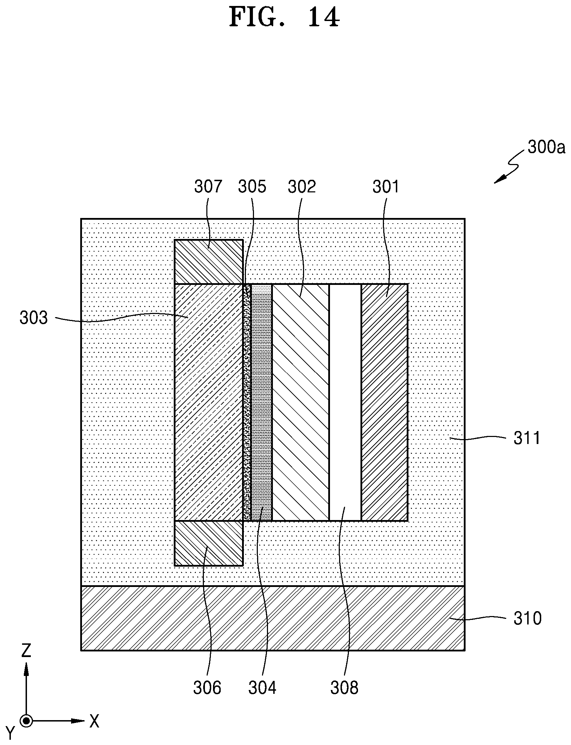

FIG. 14 is a cross-sectional view schematically showing a structure of a ferroelectric field effect transistor according to at least one embodiment. Referring to FIG. 14, a ferroelectric field effect transistor 300a may further include a gate intermediate layer 308 provided between a gate electrode 301 and a ferroelectric layer 302 in a second direction. Other configurations of the ferroelectric field effect transistor 300a may be the same as (or substantially similar to) those of the ferroelectric field effect transistor 300 shown in FIG. 13. The gate intermediate layer 308 may extend in the first direction as in other layers. The gate intermediate layer 308 may be the same as the gate intermediate layer 108 described with reference to FIG. 6. For example, the gate intermediate layer 308 may include at least one amorphous dielectric material from among silicon oxide (SiO), silicon nitride (SiN), aluminum oxide (AlO), and silicon oxynitride (SiON). When the gate intermediate layer 308 includes amorphous silicon oxynitride (SiON), the concentration of oxygen in the gate intermediate layer 308 decreases with distance towards the ferroelectric layer 302 and increases with distance towards the gate electrode 301, and the concentrations of nitrogen and silicon may increase with distance towards the ferroelectric layer 302 and decrease with distance towards the gate electrode 301.

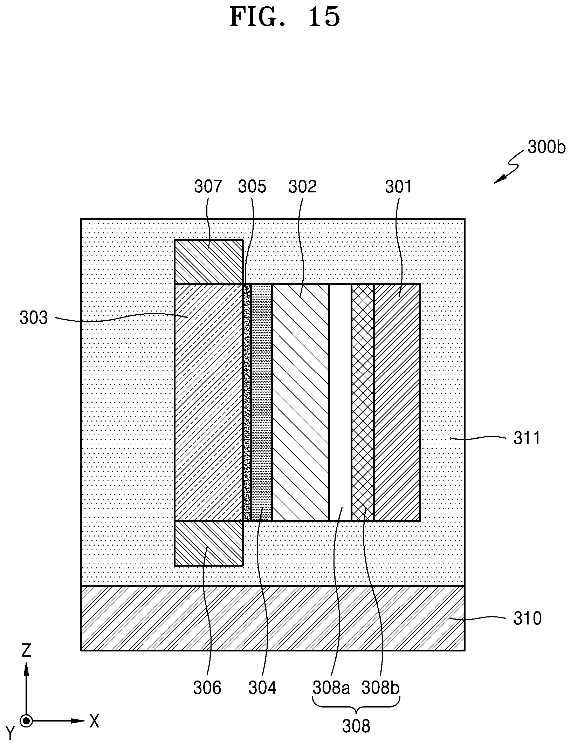

FIG. 15 is a cross-sectional view schematically showing a structure of a ferroelectric field effect transistor according to at least one embodiment. Referring to FIG. 15, the gate intermediate layer 308 of the ferroelectric field effect transistor 300b according to at least one embodiment may include a first gate intermediate layer 308a adjacent to the ferroelectric layer 302 in the second direction and a second gate intermediate layer 308b adjacent to the gate electrode 301 in the second direction. The first gate intermediate layer 308a and the second gate intermediate layer 308b may extend in the first direction. The first gate intermediate layer 308a may be the same as the first gate intermediate layer 108a described with reference to FIG. 8, and the second gate intermediate layer 308b may be the same as (or substantially similar to) the second gate intermediate layer 108b described with reference to FIG. 8. For example, the first gate intermediate layer 308a may include amorphous silicon nitride (SiN) or amorphous silicon oxynitride (SiON), and the second gate intermediate layer 308b may include amorphous silicon oxide (SiO) having a relatively low dielectric constant. When the first gate intermediate layer 308a includes amorphous silicon oxynitride (SiON), the concentration of oxygen in the gate intermediate layer 308a decreases with distance towards the ferroelectric layer 302 and increases with distance towards the gate electrode 301, and the concentrations of nitrogen and silicon may increase with distance towards the ferroelectric layer 302 and decrease with distance towards the gate electrode 301.

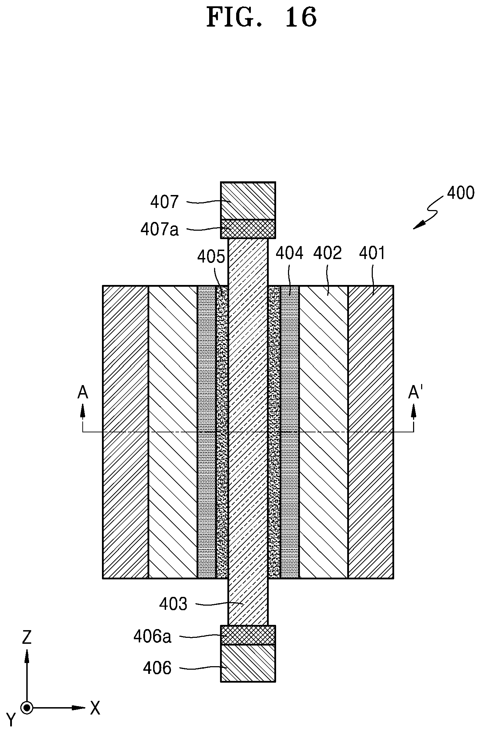

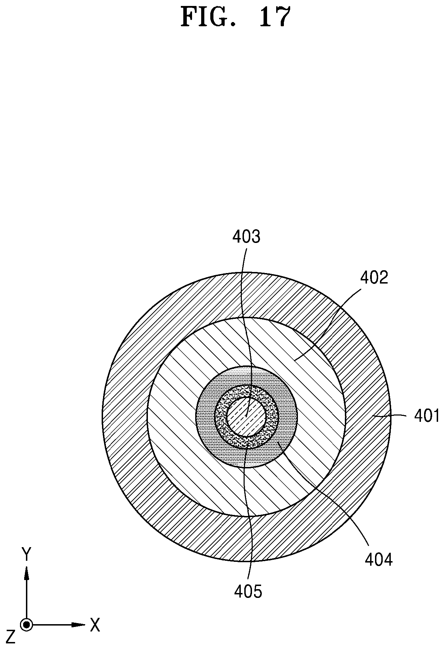

Although the ferroelectric field effect transistors of the vertical channel structure shown in FIGS. 13 to 15 include a plurality of flat plate-shaped layers extending in the vertical direction and arranged in the horizontal direction, a plurality of layers may be arranged in a concentric form. FIGS. 16 and 17 are vertical and horizontal cross-sectional views schematically showing a structure of a ferroelectric field effect transistor according to at least one embodiment, respectively. FIG. 17 is a schematic view taken along line A-A' of FIG. 16. Referring to FIGS. 16 and 17, the ferroelectric field effect transistor 400 may include a cylindrical channel layer 403 extending in the vertical direction or a first direction (Z-axis direction), a diffusion barrier layer 405 surrounding the channel layer 403, an oxygen-deficient layer 404 surrounding the diffusion barrier layer 405, a ferroelectric layer 402 surrounding the oxygen-deficient layer 404, and a gate electrode 401 surrounding the ferroelectric layer 402. The channel layer 403, the diffusion barrier layer 405, the oxygen-deficient layer 404, the ferroelectric layer 402, and the gate electrode 401 may extend in the vertical direction or a first direction (Z-axis direction) and may be arranged in a concentric form. The materials, compositions, and functions of the layers illustrated in FIGS. 16 and 17 are the same as (or substantially similar to) the materials, compositions, and functions of the layers described in FIG. 13, and thus a detailed description thereof is omitted.

The ferroelectric field effect transistor 400 may also include a source electrode 406 provided on a lower surface of the channel layer 403 and a drain electrode 407 provided on an upper surface of the channel layer 403. In other words, the source electrode 406 and the drain electrode 407 may be provided at both ends of the channel layer 403 in the first direction, respectively. In addition, the ferroelectric field effect transistor 400 may further include a first contact layer 406a provided between the channel layer 403 and the source electrode 406, and a second contact layer 407a provided between the channel layer 403 and the drain electrode 407.

The channel layer 403 may further protrude in a first direction with respect to other layers, that is, the diffusion barrier layer 405, the oxygen-deficient layer 404, the ferroelectric layer 402, and the gate electrode 401. In other words, the length of the channel layer 403 in the first direction may be greater than the lengths of the diffusion barrier layer 405, the oxygen-deficient layer 404, the ferroelectric layer 402, and the gate electrode 401 in the first direction. Although not shown in FIGS. 13 to 15, even in FIGS. 13 to 15, the length of the channel layer 303 may be greater than the lengths of other layers. In these cases, the widths of the source electrode 406 and the drain electrode 407 in the second direction may not be limited. Alternatively, in the case of FIGS. 16 and 17, the length of the channel layer 403 in the first direction may be the same as the lengths of the diffusion barrier layer 405, the oxygen-deficient layer 404, the ferroelectric layer 402, and the gate electrode 401 in the first direction. In these cases, widths of the source electrode 406 and the drain electrode 407 in the second direction may be limited such that the source electrode 406 and the drain electrode 407 are not in contact with the oxygen-deficient layer 404.

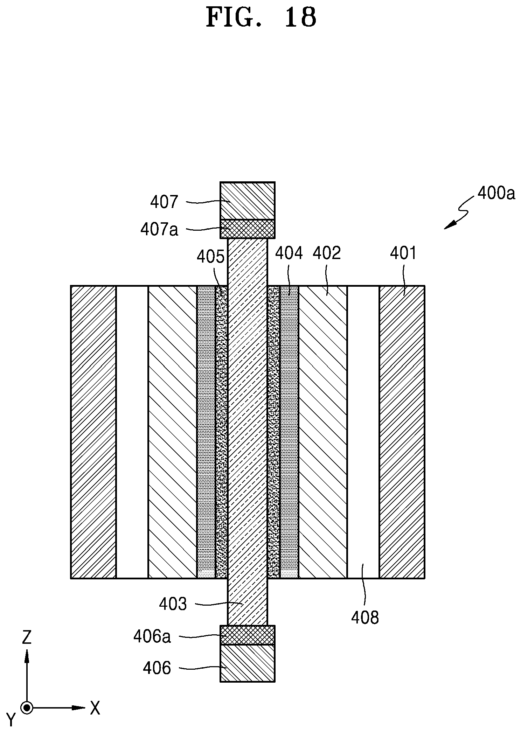

FIG. 18 is a cross-sectional view schematically showing a structure of a ferroelectric field effect transistor according to at least one embodiment. Referring to FIG. 18, a ferroelectric field effect transistor 400a may further include a gate intermediate layer 408 provided between a gate electrode 401 and a ferroelectric layer 402 in a second direction. Other configurations of the ferroelectric field effect transistor 400a may be the same as those of the ferroelectric field effect transistor 400 shown in FIGS. 16 and 17. The gate intermediate layer 408 may extend in the first direction as in other layers. The gate intermediate layer 408 may surround the ferroelectric layer 402, and the gate electrode 401 may surround the gate intermediate layer 408. The gate intermediate layer 408 may include the same material as the gate intermediate layer 108 described with reference to FIG. 6.

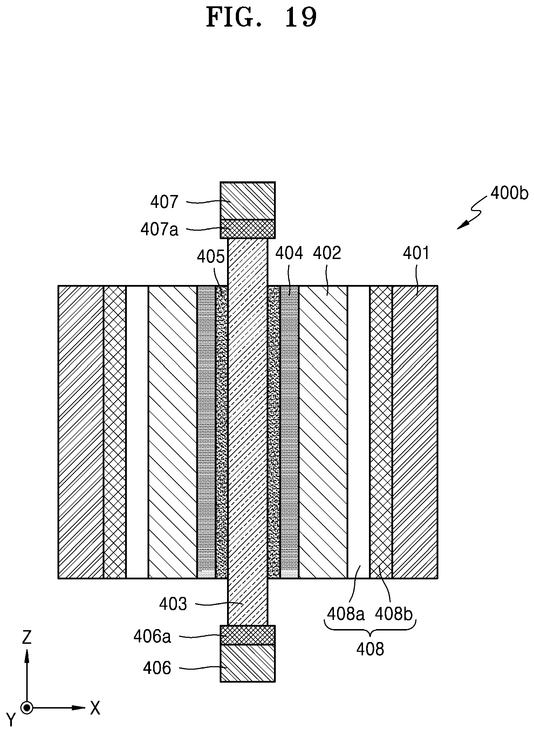

FIG. 19 is a cross-sectional view schematically showing a structure of a ferroelectric field effect transistor according to at least one embodiment. Referring to FIG. 19, the gate intermediate layer 408 of the ferroelectric field effect transistor 400b according to at least one embodiment may include a first gate intermediate layer 408a adjacent to the ferroelectric layer 402 in the second direction and a second gate intermediate layer 408b adjacent to the gate electrode 401 in the second direction. The first gate intermediate layer 408a and the second gate intermediate layer 408b may extend in the first direction. The first gate intermediate layer 408a may surround the ferroelectric layer 402, the second gate intermediate layer 408b may surround the first gate intermediate layer 408a, and the gate electrode 401 may surround the second gate intermediate layer 408b. The first gate intermediate layer 408a may include the same (or substantially similar) material as the first gate intermediate layer 108a described with reference to FIG. 8, and the second gate intermediate layer 408b may include the same (or substantially similar) material as the second gate intermediate layer 108b described with reference to FIG. 8.

The configuration including the oxide semiconductor channel layer, the diffusion barrier layer, and the oxygen-deficient layer described above may be applied to a memory device having a vertical NAND (VNAND) architecture, which is a three-dimensional (or vertical) NAND (NOT-AND).

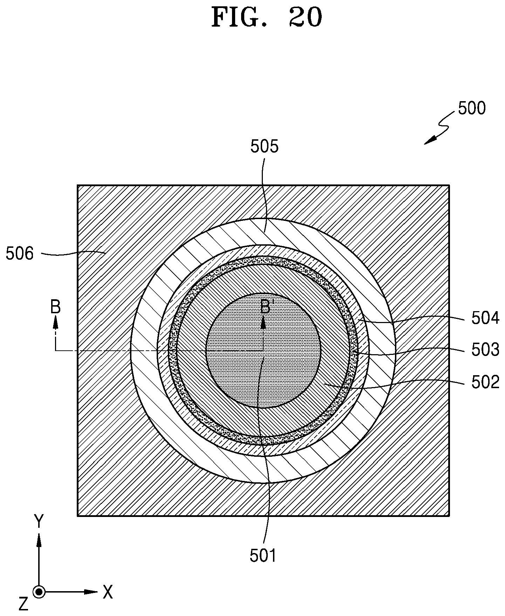

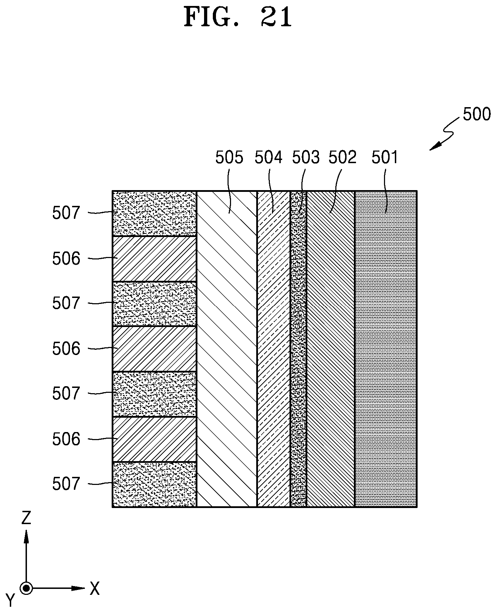

FIGS. 20 and 21 are horizontal and vertical cross-sectional views schematically showing a structure of a memory cell string of a memory device according to at least one embodiment, respectively. Referring to FIG. 20, a memory cell string 500 of a memory device according to at least one embodiment may include a central filling material 501, a channel layer 502, a diffusion barrier layer 503, an oxygen-deficient layer 504, a ferroelectric layer 505, and a gate electrode 506 concentrically provided on an XY plane. For example, the channel layer 502 may be provided to surround the central filling material 501 having a cylindrical shape, the diffusion barrier layer 503 may be provided to surround the channel layer 502, the oxygen-deficient layer 504 may be provided to surround the diffusion barrier layer 503, the ferroelectric layer 505 may be provided to surround the oxygen-deficient layer 504, and the gate electrode 506 may be provided to surround the ferroelectric layer 505. The central filling material 501 may serve to support the channel layer 502 and the memory cell string 500 by filling a space on the inner wall side of the channel layer 502. However, the central filling material 501 is not an essential component and may be omitted. In this case, an empty space may exist instead of the central filling material 501.

FIG. 21 schematically shows a structure of a memory cell string 500 taken in a first direction (e.g., the Z-axis direction) from the center of the central filling material 501 to the gate electrode 506 along the line B-B' in FIG. 20. Referring to FIG. 21, the memory cell string 500 may include a plurality of gate electrodes 506 and a plurality of spacers 507 alternately arranged in a first direction, a channel layer 502 facing and being spaced apart from the plurality of gate electrodes 506 and the plurality of spacers 507 in a second direction (e.g., an X-axis direction), a ferroelectric layer 505 continuously extending in the first direction and provided between the channel layer 502 and the plurality of gate electrodes 506, an oxygen-deficient layer 504 continuously extending in the first direction and provided between the ferroelectric layer 505 and the channel layer 502, and a diffusion barrier layer 503 extending continuously in the first direction and provided between the oxygen-deficient layer 504 and the channel layer 502. In addition, the memory cell string 500 may further include a central filling material 501 continuously extending in the first direction inside the channel layer 502. In other words, the ferroelectric layer 505, the oxygen-deficient layer 504, the diffusion barrier layer 503, the channel layer 502, and the central filling material 501 may be sequentially provided in the second direction from the plurality of gate electrodes 506 and the plurality of spacers 507.

Each of the plurality of spacers 507 may include silicon oxide ($SiO_2$) having insulating properties, but the embodiments are not limited thereto. The ferroelectric layer 505 may include the same (or substantially similar) ferroelectric material as the ferroelectric layer 102 described with reference to FIG. 1, the channel layer 502 may include the same (or substantially similar) oxide semiconductor material as the channel layer 103 described with reference to FIG. 1, and the oxygen-deficient layer 504 may include the same (or substantially similar) oxide semiconductor material as the oxygen-deficient layer 104 described with reference to FIG. 1. In addition, the diffusion barrier layer 503 may include the same (or substantially similar) nitride material as the diffusion barrier layer 105 described with reference to FIG. 1. In addition, the oxygen-deficient layer 504 may include oxygen vacancies of a high concentration, which is the same as (or substantially similar to) the oxygen-deficient layer 104 described with reference to FIG. 1. The concentration of oxygen vacancies in the oxygen-deficient layer 504 may be higher than that of oxygen vacancies in the channel layer 502.

Although not shown, a source electrode and a drain electrode may be electrically connected to both ends of the channel layer 502 in the first direction. For example, a source electrode may be provided at a lower side of the channel layer 502, and a drain electrode may be provided at an upper side of the channel layer 502. The source electrode and the drain electrode may extend to be in contact with the central filling material 501, the channel layer 502, and the diffusion barrier layer 503 in the second direction. However, in at least some embodiments, the source electrode and the drain electrode may not be in contact with the oxygen-deficient layer 504. In other words, the source electrode and the drain electrode may extend to the diffusion barrier layer 503 in the second direction, but may not extend to the oxygen-deficient layer 504. However, when it is difficult to limit the widths of the source electrode and the drain electrode due to the restriction on the process, the source electrode and the drain electrode may be in contact with the oxygen-deficient layer 504, and in these cases, the leakage current may increase slightly.

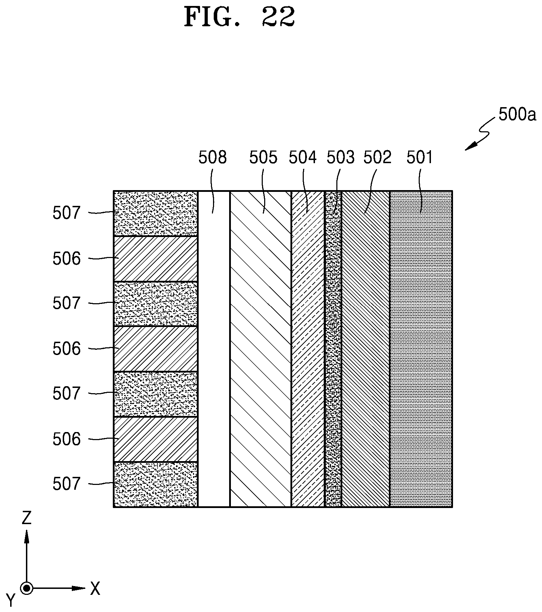

FIG. 22 is a cross-sectional view schematically illustrating a structure of a memory cell string of a memory device, according to at least one embodiment. Referring to FIG. 22, a memory cell string 500a may further include a gate intermediate layer 508 continuously extending in a first direction and provided between a plurality of gate electrodes 506 and a ferroelectric layer 505. Since the configuration of the memory cell string 500a excluding the gate intermediate layer 508 is the same as (or substantially similar to) the configuration of the memory cell string 500 shown in FIGS. 20 and 21, a detailed description thereof is omitted.

The gate intermediate layer 508 may be the same as (or substantially similar to) the gate intermediate layer 108 described with reference to FIG. 6. For example, the gate intermediate layer 508 may include at least one amorphous dielectric material from among silicon oxide (SiO), silicon nitride (SiN), aluminum oxide (AlO), and silicon oxynitride (SiON). In addition, when the gate intermediate layer 508 includes amorphous silicon oxynitride (SiON), the concentration of oxygen in the gate intermediate layer 508 decreases with distance towards the ferroelectric layer 505 and increases with distance towards the gate electrode 506, and the concentrations of nitrogen and silicon may increase as it gets closer to the ferroelectric layer 505 and decrease with distance towards the gate electrode 506. In other words, the gate intermediate layer 508 includes a first surface adjacent to the gate electrode 506 and a second surface adjacent to the ferroelectric layer 505, and the concentration of oxygen in the gate intermediate layer 508 may gradually decrease from the first surface toward the second surface, and the concentrations of nitrogen and silicon may gradually increase from the first surface toward the second surface.

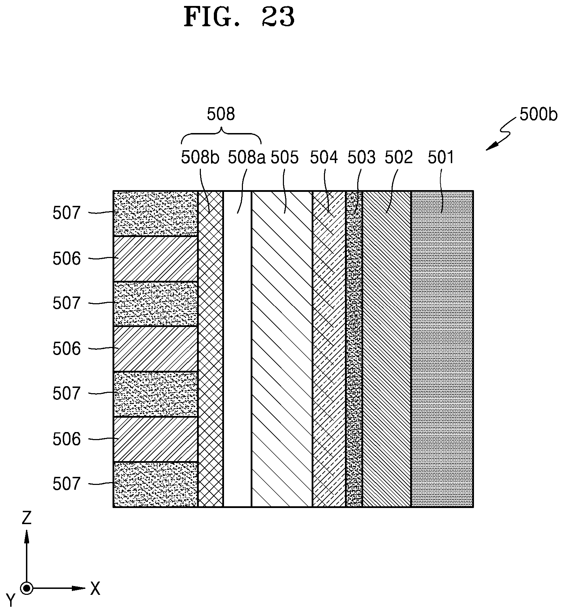

FIG. 23 is a cross-sectional view schematically illustrating a structure of a memory cell string of a memory device, according to at least one embodiment. Referring to FIG. 23, in the memory cell string 500b according to at least one embodiment, the gate intermediate layer 508 may have a multi-layered structure. For example, the gate intermediate layer 508 may include a first gate intermediate layer 508a adjacent to the ferroelectric layer 505 and a second gate intermediate layer 508b adjacent to the gate electrode 506. The first gate intermediate layer 508a may be the same as (or substantially similar to) the first gate intermediate layer 108a described with reference to FIG. 8, and the second gate intermediate layer 508b may be the same as (or substantially similar to) the second gate intermediate layer 108b described with reference to FIG. 8. For example, the first gate intermediate layer 508a may include amorphous silicon nitride (SiN) or amorphous silicon oxynitride (SiON), and the second gate intermediate layer 508b may include amorphous silicon oxide (SiO) having a relatively low dielectric constant. When the first gate intermediate layer 508a includes amorphous silicon oxynitride (SiON), the concentration of oxygen in the gate intermediate layer 508a decreases with distance towards the ferroelectric layer 505 and increases with distance towards the gate electrode 506, and the concentrations of nitrogen and silicon may increase with distance towards to the ferroelectric layer 505 and decrease with distance towards the gate electrode 506. In other words, the first gate intermediate layer 508a includes a first surface adjacent to the gate electrode 506 and a second surface adjacent to the ferroelectric layer 505, and the concentration of oxygen in the first gate intermediate layer 508a may gradually decrease from the first surface toward the second surface, and the concentrations of nitrogen and silicon may gradually increase from the first surface toward the second surface.

Within the memory cell strings 500, 500a, and 500b shown in FIGS. 20 to 23, the gate electrode 506, a portion of the gate intermediate layer 508 adjacent to the gate electrode 506, in the second direction, a portion of the ferroelectric layer 505, a portion of the oxygen-deficient layer 504, a portion of the diffusion barrier layer 503, and a portion of the channel layer 502 may form one memory cell. In this matter, it may be considered that the memory cell strings 500, 500a, and 500b include a plurality of memory cells stacked in the first direction. In addition, a memory device having a VNAND structure may include the plurality of memory cell strings 500, 500a, and 500b provided in two dimensions.

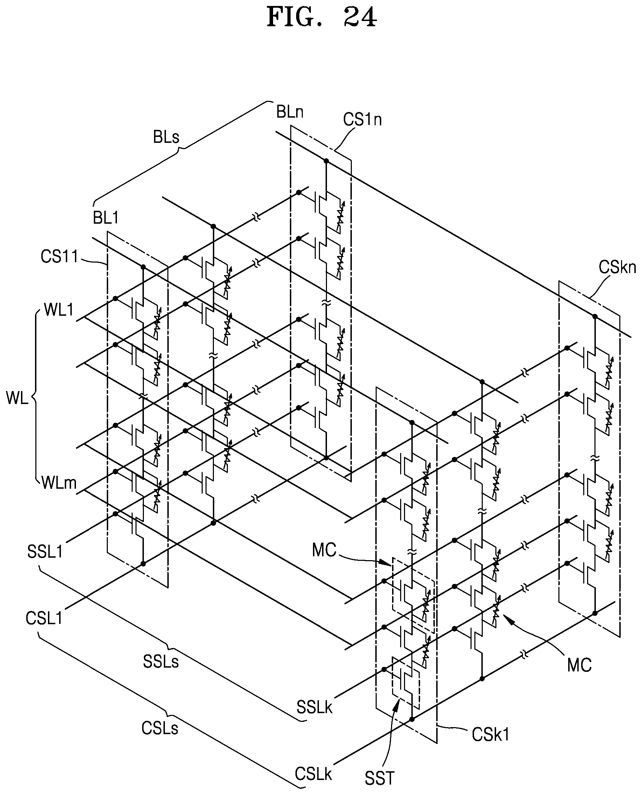

FIG. 24 is a diagram illustrating an equivalent circuit of a memory device according to at least one embodiment. Referring to FIG. 24, the memory device may include a plurality of memory cell strings CS11 to CSkn. The plurality of memory cell strings CS11 to CSkn may be two-dimensionally provided in a row direction and a column direction, thereby forming rows and columns. Each of the memory cell strings CS11 to CSkn may include a plurality of memory cells MC and a plurality of string selection transistors SST. The memory cells MC and the string selection transistors SST of each of the memory cell strings CS11 to CSkn may be stacked in a height direction. Each of the memory cells MC in each of the memory cell strings CS11 to CSkn may correspond to a circuit in which a transistor and a resistor are connected in parallel. For example, each of the memory cell strings CS11 to CSkn may be one of the memory cell strings 500, 500a, and 500b illustrated in FIGS. 20 to 23 and/or include any one of the ferroelectric field effect transistors described with reference to FIGS. 1 to 19.

Rows of the plurality of memory cell strings CS11 to CSkn may be connected to a plurality of string selection lines SSL1 through SSLk, respectively. For example, the string selection transistors SST of the memory cell strings CS11 to CS1n may be commonly connected to the string selection line SSL1. The string selection transistors SST of the memory cell strings CSk1 to CSkn may be commonly connected to the string selection line SSLk.

In addition, columns of the plurality of memory cell strings CS11 to CSkn may be connected to the plurality of bit lines BL1 through BLn, respectively. For example, the memory cells MC and the string selection transistors SST of the memory cell strings CS11 to CSk1 may be commonly connected to the bit line BL1, and the memory cells MC and the string selection transistors SST of the memory cell strings CS1n to CSkn may be commonly connected to the bit line BLn.

In addition, the rows of the plurality of memory cell strings CS11 to CSkn may be connected to the plurality of common source lines CSL1 to CSLk, respectively. For example, the string selection transistors SST of the plurality of memory cell strings CS11 to CS1n may be commonly connected to the common source line CSL1, and the string selection transistors SST of the plurality of memory cell strings CSk1 to CSkn may be commonly connected to the common source line CSLk.

The memory cells MC located at the same height from a substrate (or the string selection transistors SST) may be commonly connected to one word line WL, and the memory cells MC located at different heights from the substrate (or the string selection transistors SST) may be connected to the plurality of word lines WL1 through WLm, respectively.

In such a structure, writing and reading may be performed in units of rows of memory cell strings CS11 to CSkn. For example, the memory cell strings CS11 to CSkn may be selected for each row by the common source lines CSL, and the memory cell strings CS11 to CSkn may be selected for each row by the string selection lines SSLs. In addition, the writing and reading operations may be performed for each page, in a selected row of the memory cell strings CS11 to CSkn. For example, the page may be one row of the memory cells MC connected to one word line WL. In the selected row of the memory cell strings CS11 to CSkn, the memory cells MC may be selected for each page by the word lines WL.

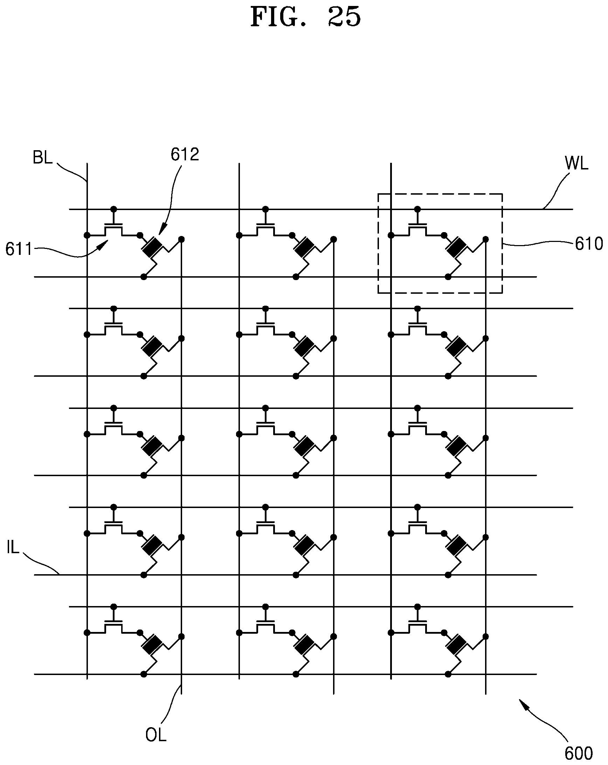

FIG. 25 is a schematic circuit diagram of a neural network device according to at least one embodiment. Referring to FIG. 25, a neural network device 600 according to at least one embodiment may include an array of a plurality of synapse devices (or elements) 610 arranged in two dimensions. Each of the plurality of synapse devices 610 may include an access transistor 611 and a ferroelectric field effect transistor 612. The ferroelectric field effect transistor 612 may be any one of the ferroelectric field effect transistors described with reference to FIGS. 1 to 19. The access transistor 611 may serve as a selection element for turning on/off the synapse device 610.

The neural network device 600 may also include a plurality of word lines WL, a plurality of bit lines BL, a plurality of input lines IL, and a plurality of output lines OL. The gate of the access transistor 611 may be electrically connected to any one of the plurality of word lines WL, the source thereof may be electrically connected to any one of the plurality of bit lines BL, and the drain thereof may be connected to the gate of the ferroelectric field effect transistor 612. Further, the source of the ferroelectric field effect transistor 612 may be electrically connected to any one of the plurality of input lines IL, and a drain thereof may be electrically connected to any one of the plurality of output lines OL.

During the learning operation of the neural network device 600, the access transistor 611 is individually turned on through individual word lines WL, and a program pulse may be applied to the gate of the ferroelectric field effect transistor 612 through the bit lines BL. A signal of the training data may be applied through the input line IL. Through this process, weights may be stored in each ferroelectric field effect transistor 612.

During the inference operation of the neural network device 600, all access transistors 611 may be turned on through the entire word lines WL, and a read voltage Vread may be applied through the bit lines BL. Then, the current from synapse devices 610 connected in parallel to the output line OL is added to and flows in each output line OL. An output circuit is connected to the plurality of output lines OL to convert a current flowing through each output line OL into a digital signal.

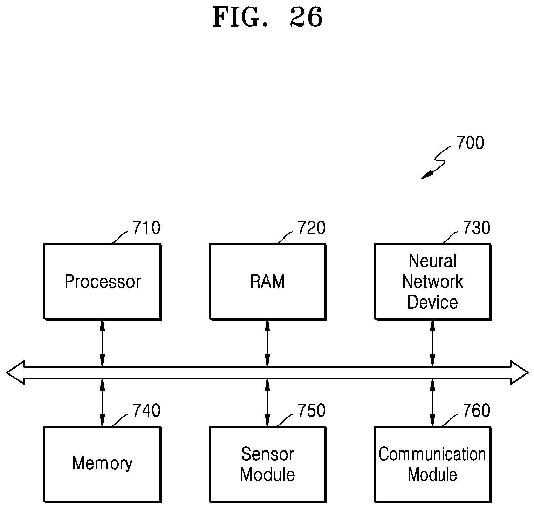

FIG. 26 is a schematic block diagram showing an example configuration of an electronic device including a neural network device. Referring to FIG. 26, the electronic device 700 may analyze input data in real time based on a neural network to extract valid information, determine a situation based on the extracted information, or control configurations of a device equipped with the electronic device 700. For example, the electronic device 700 may be applied to a robot device such as a drone, an advanced driver assistance system (ADAS), or the like, a smart TV, a smartphone, a medical device, a mobile device, an image display device, a measurement device, and an IoT device, and the like, and may be mounted on at least one of various types of devices.

The electronic device 700 may include a processor 710, a random access memory (RAM) 720, a neural network device 730, a memory 740, a sensor module 750, and a communication module 760. The electronic device 700 may further include an input/output module, a security module, a power control device, and the like. Some of the hardware components of the electronic device 700 may be mounted on at least one semiconductor chip.

The processor 710 controls the overall operation of the electronic device 700. The processor 710 may include a single processor core or a plurality of processor cores (e.g., MultiCore). The processor 710 may process or execute programs and/or data stored in the memory 740. In some embodiments, the processor 710 may control the function of the neural network device 730 by executing programs stored in the memory 740. The processor 710 may be implemented as a central processing unit (CPU), a graphics processing unit (GPU), an application processor (AP), or the like.

The RAM 720 may temporarily store programs, data, or instructions. For example, programs and/or data stored in the memory 740 may be temporarily stored in the RAM 720 according to the control or boot code of the processor 710. The RAM 720 may be implemented as a memory such as dynamic RAM (DRAM), static RAM (SRAM), or the like.

The neural network device 730 may perform an operation of the neural network based on the received input data and generate an information signal based on the execution result. The neural network may include, but is not limited to, CNN, RNN, FNN, long short-term memory (LSTM), stacked neural network (SNN), state-space dynamic neural network (SSDNN), deep belief networks (DBN), restricted Boltzmann machine (RBM), and the like. The neural network device 730 may be a hardware accelerator dedicated to a neural network or a device including the same. The neural network device 730 may perform a read or write operation as well as an operation of the neural network. The neural network device 730 may correspond to the neural network device 600 according to the embodiment illustrated in FIG. 25.

The information signal may include one of various types of recognition signals such as a voice recognition signal, an object recognition signal, an image recognition signal, a biometric information recognition signal, and the like. For example, the neural network device 730 may receive frame data included in the video stream as input data and generate, from frame data, a recognition signal for an object included in an image represented by the frame data. However, the neural network device is not limited thereto, and the neural network device 730 may receive various types of input data and generate a recognition signal according to the input data according to the type or function of the device on which the electronic device 700 is mounted.

The neural network device 730 may perform, for example, machine learning model such as linear regression, logistic regression, statistical clustering, Bayesian classification, decision trees, principal component analysis, and/or expert system, and/or machine learning model of ensemble techniques, etc., such as random forest. The machine learning model may be used to provide various services such as, for example, image classification service, user authentication service based on biometric information or biometric data, advanced driver assistance system (ADAS), voice assistant service, automatic speech recognition (ASR) service, and the like.

The memory 740 is a storage place for storing data and may store an operating system (OS), various programs, and various pieces of data. In at least one embodiment, the memory 740 may store intermediate results generated during the operation of the neural network device 730.

The memory 740 may be a DRAM, but is not limited thereto. The memory 740 may include at least one of a volatile memory and a nonvolatile memory. The nonvolatile memory includes read-only memory (ROM), programmable ROM (PROM), electrically programmable ROM (EPROM), electrically erasable and programmable ROM (EEPROM), flash memory, phase-change ROM (PROM), magnetic ROM (MROM), resistive ROM (RROM), ferroelectric ROM (FROM), and the like. The volatile memory includes dynamic RAM (DRAM), static RAM (SRAM), synchronous DRAM (SDRAM), phase-change RAM (PRAM), magnetic RAM (MRAM), resistive RAM (RRAM), and ferroelectric RAM (FeRAM). In at least one embodiment, the memory 740 may include at least one of a hard disk drive (HDD), a solid state drive (SSD), a compact flash (CF), a secure digital (SD), a micro secure digital (Micro-SD), a mini secure digital (Mini-SD), and a memory stick.

The sensor module 750 may collect information around a device on which the electronic device 700 is mounted. The sensor module 750 may sense or receive a signal (e.g., an image signal, a voice signal, a magnetic signal, a bio signal, a touch signal, etc.) from the outside of the electronic device 700 and convert the sensed or received signal into data. To this end, the sensor module 750 may include at least one of various types of sensing devices such as a sensing device, for example, a microphone, an imaging device, an image sensor, a light detection and ranging (LIDAR) sensor, an ultrasonic sensor, an infrared sensor, a biosensor, and a touch sensor.

The sensor module 750 may provide the converted data to the neural network device 730 as input data. For example, the sensor module 750 may include an image sensor, generate a video stream by photographing an external environment of the electronic device 700, and sequentially provide the continuous data frame of the video stream to the neural network device 730 as input data. However, embodiments are not limited thereto, and the sensor module 750 may provide various types of data to the neural network device 730.

The communication module 760 may include various wired or wireless interfaces capable of communicating with an external device. For example, the communication module 760 may include a wired local area network (LAN), a wireless local area network (WLAN) such as a wireless fidelity (Wi-Fi), a wireless personal area network (WPAN) such as Bluetooth, a wireless universal serial bus (USB), Zigbee, near field communication (NFC), radio-frequency identification (RFID), power line communication (PLC), and a communication interface capable of connecting to a mobile cellular network, such as 3rd generation (3G), 4th generation (4G), long term evolution (LTE), and/or the like.

The ferroelectric field effect transistor, the memory device, and the neural network device described above have been described with reference to the embodiments shown in the drawings, which are only nonlimiting examples.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1. A ferroelectric field effect transistor comprising:

a channel layer;
a gate electrode facing the channel layer;
a ferroelectric layer between the channel layer and the gate electrode;
an oxygen-deficient layer between the channel layer and the ferroelectric layer;
a diffusion barrier layer between the channel layer and the oxygen-deficient layer and configured to reduce or prevent oxygen exchange between the channel layer and the oxygen-deficient layer; and
a source electrode and a drain electrode electrically connected to the channel layer, wherein the channel layer and the oxygen-deficient layer each include an oxide semiconductor material, and
a concentration of oxygen vacancies in the oxygen-deficient layer is greater than a concentration of oxygen vacancies in the channel layer.

2. The ferroelectric field effect transistor of claim 1, wherein the diffusion barrier layer comprises a nitride material.

3. The ferroelectric field effect transistor of claim 2, wherein the nitride material of the diffusion barrier layer comprises at least one of silicon nitride (SiN), hafnium nitride (HfN), or aluminum nitride (AlN).

4. The ferroelectric field effect transistor of any preceding claim, wherein the oxide semiconductor material of the oxygen-deficient layer has a stoichiometrically oxygen-deficient composition.

5. The ferroelectric field effect transistor of any preceding claim, wherein

a thickness of the oxygen-deficient layer is less than a thickness of the channel layer, and
a thickness of the diffusion barrier layer is less than a thickness of the oxygen-deficient layer, and optionally wherein:

a total thickness of the channel layer and the oxygen-deficient layer is 10 nanometers (nm) to 20 nm;
the thickness of the oxygen-deficient layer is 1 nm to 5 nm; and
the thickness of the diffusion barrier layer is 0.1 nm to 3 nm.

6. The ferroelectric field effect transistor of any preceding claim, further comprising:
a gate intermediate layer between the gate electrode and the ferroelectric layer, wherein the gate intermediate layer comprises at least one amorphous dielectric material, the at least one amorphous dielectric material including silicon oxide, silicon nitride, aluminum oxide, or silicon oxynitride.

7. The ferroelectric field effect transistor of claim 6, wherein

the amorphous dielectric material of the gate intermediate layer comprises amorphous silicon oxynitride,
the gate intermediate layer comprises: a first surface adjacent to the gate electrode; and a second surface adjacent to the ferroelectric layer,
a nitrogen concentration of the gate intermediate layer gradually increases from the first surface toward the second surface, and
an oxygen concentration of the gate intermediate layer gradually decreases from the first surface toward the second surface.

8. The ferroelectric field effect transistor of claim 7, wherein

an oxygen concentration at the first surface of the gate intermediate layer is higher by a ratio of 10% or more relative to an oxygen concentration at the second surface of the gate intermediate layer, and
the nitrogen concentration at the second surface of the gate intermediate layer is greater by a ratio of 10% or more relative to the nitrogen concentration at the first surface of the gate intermediate layer.

9. The ferroelectric field effect transistor of claim 7 or 8, wherein

a silicon concentration of the gate intermediate layer gradually increases from the first surface toward the second surface.

the silicon concentration at the second surface of the gate intermediate layer is greater by a ratio of 10% or more relative to the silicon concentration at the first surface of the gate intermediate layer, and optionally wherein a ratio of the silicon concentration to the nitrogen concentration at the first surface of the gate intermediate layer is the same as a ratio of the silicon concentration to the nitrogen concentration at the second surface of the gate intermediate layer.

10. The ferroelectric field effect transistor of any of claims 6 to 9, wherein

the gate intermediate layer comprises a first gate intermediate layer adjacent to the ferroelectric layer and a second gate intermediate layer adjacent to the gate electrode,

the first gate intermediate layer comprises at least one of amorphous silicon nitride or amorphous silicon oxynitride, and

the second gate intermediate layer comprises amorphous silicon oxide (SiO), and optionally wherein:

the first gate intermediate layer comprises the amorphous silicon oxynitride;

the first gate intermediate layer comprises: a first surface adjacent to the gate electrode; and a second surface adjacent to the ferroelectric layer;

a nitrogen concentration of the first gate intermediate layer gradually increases from the first surface toward the second surface; and

an oxygen concentration of the first gate intermediate layer gradually decreases from the first surface toward the second surface, and further optionally wherein:

a silicon concentration in the first gate intermediate layer gradually increases from the first surface toward the second surface; and

a ratio of the silicon concentration to the nitrogen concentration at the first surface of the first gate intermediate layer is the same as a ratio of the silicon concentration to the nitrogen concentration at the second surface of the first gate intermediate layer.

11. The ferroelectric field effect transistor of any preceding claim, wherein

the channel layer comprises a first surface and a second surface facing each other, and

the source electrode and the drain electrode are spaced apart from each other on the first surface of the channel layer, and the gate electrode faces the second surface of the channel layer.

12. The ferroelectric field effect transistor of any of claims 1 to 10, wherein

the channel layer comprises a first surface and a second surface facing each other,

the gate electrode faces the first surface of the channel layer,

the source electrode and the drain electrode are spaced apart from each other on the first surface of the channel layer,

the diffusion barrier layer is on the first surface of the channel layer between the source electrode and the drain electrode,

the oxygen-deficient layer is on the diffusion barrier layer between the source electrode and the drain electrode,

the source electrode faces and is spaced apart from a first side surface of the oxygen-deficient layer, and the drain electrode faces and is spaced apart from a second side surface of the oxygen-deficient layer, and

the second side surface of the oxygen-deficient layer is opposite to the first side surface of the oxygen-deficient layer.

13. The ferroelectric field effect transistor of any preceding claim, wherein

the channel layer, the diffusion barrier layer, the oxygen-deficient layer, the ferroelectric layer, and the gate electrode extend in a first direction and are sequentially arranged in a second direction perpendicular to the first direction, and

the source electrode and the drain electrode are electrically connected to respective ends of the channel layer in the first direction, and optionally wherein the channel layer has a cylindrical shape such that the diffusion barrier layer surrounds the channel layer, the oxygen-deficient layer surrounds the diffusion barrier layer, the ferroelectric layer surrounds the oxygen-deficient layer, and the gate electrode surrounds the ferroelectric layer.

14. A memory device comprising:
    a plurality of ferroelectric field effect transistors according to any preceding claim.

15. A neural network device comprising:
    an array of a plurality of synapse devices, wherein each of the plurality of synapse devices includes an access transistor and a ferroelectric field effect transistor according to any of claims 1 to 13.

FIG. 1

FIG. 2

# FIG. 3

# FIG. 4

# FIG. 5

FIG. 6

# FIG. 7

# FIG. 8

100b

| Label | |
|---|---|
| 106 | 107 |
| 106a | 107a |
| | 103 |
| 105 | 104 |
| | 102 |
| | 108a |
| | 108 |
| | 108b |
| 101 | |

FIG. 9

# FIG. 10

200a

201

208

202

207

207a

206

206a

203      204      205

FIG. 11

FIG. 12

# FIG. 13

# FIG. 14

# FIG. 15

# FIG. 16

# FIG. 17

# FIG. 18

407

407a

405   404 402   401

400a

403

408

406a

406

Z

Y   X

# FIG. 19

# FIG. 20

# FIG. 21

# FIG. 22

500a

508 505 504 503 502 501

507

506

507

506

507

506

507

Z

Y X

# FIG. 23

# FIG. 24

# FIG. 25

# FIG. 26

700

710
Processor

720
RAM

730
Neural
Network
Device

740
Memory

750
Sensor
Module

760
Communication
Module

# EUROPEAN SEARCH REPORT

**Application Number**

EP 25 17 2322

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHEN ZHUO ET AL: "Improved MW of IGZO-channel FeFET by Reading Scheme Optimization and Interfacial Engineering", 2023 IEEE INTERNATIONAL MEMORY WORKSHOP (IMW), IEEE, 21 May 2023 (2023-05-21), pages 1-4, XP034359372, DOI: 10.1109/IMW56887.2023.10145930 [retrieved on 2023-06-12] * page 1 - page 2; figure 1 * | 1-15 | INV. H10D64/68 H10B51/30 H10D30/67 H10D30/69 H10D64/01 |
| A | YOO SIJUNG ET AL: "Highly Enhanced Memory Window of 17.8V in Ferroelectric FET with IGZO Channel via Introduction of Intermediate Oxygen-Deficient Channel and Gate Interlayer", 2024 IEEE SYMPOSIUM ON VLSI TECHNOLOGY AND CIRCUITS (VLSI TECHNOLOGY AND CIRCUITS), IEEE, 16 June 2024 (2024-06-16), pages 1-2, XP034679857, DOI: 10.1109/VLSITECHNOLOGYANDCIR46783.2024.10631534 [retrieved on 2024-08-26] * page 1 - page 2; figure 4 * | 1-15 | |
| A | WO 2024/047500 A1 (SEMICONDUCTOR ENERGY LAB [JP]) 7 March 2024 (2024-03-07) * paragraph [0467] * | 1-15 | TECHNICAL FIELDS SEARCHED (IPC) H10B H10D |

The present search report has been drawn up for all claims

| Place of search | Date of completion of the search | Examiner |
|---|---|---|
| Munich | 26 September 2025 | Nesso, Stefano |

## ANNEX TO THE EUROPEAN SEARCH REPORT
## ON EUROPEAN PATENT APPLICATION NO.

EP 25 17 2322

This annex lists the patent family members relating to the patent documents cited in the above-mentioned European search report.
The members are as contained in the European Patent Office EDP file on
The European Patent Office is in no way liable for these particulars which are merely given for the purpose of information.

26-09-2025

| Patent document cited in search report | Publication date | Patent family member(s) | Publication date |
|---|---|---|---|
| WO 2024047500 A1 | 07-03-2024 | CN 119769187 A | 04-04-2025 |
| | | JP WO2024047500 A1 | 07-03-2024 |
| | | KR 20250059432 A | 02-05-2025 |
| | | TW 202418956 A | 01-05-2024 |
| | | WO 2024047500 A1 | 07-03-2024 |

EPO FORM P0459

For more details about this annex : see Official Journal of the European Patent Office, No. 12/82